(19) Europäisches Patentamt
European Patent Office
Office européen des brevets

(11) **EP 4 783 810 A1**

(12) **EUROPEAN PATENT APPLICATION**

(43) Date of publication:
**29.07.2026 Bulletin 2026/31**

(21) Application number: **26153193.3**

(22) Date of filing: **21.01.2026**

(51) International Patent Classification (IPC):
**H10P 14/24** (2026.01)   **H10D 8/00** (2025.01)
**H10D 30/60** (2025.01)   **H10P 14/20** (2026.01)

(52) Cooperative Patent Classification (CPC):
**H10P 14/3408; H10D 8/00; H10D 30/60;**
**H10P 14/24; H10P 14/2904**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority:  **27.01.2025  JP 2025011533**
                **31.10.2025  JP 2025185113**

(71) Applicant: **Proterial, Ltd.**
**Tokyo 135-0061 (JP)**

(72) Inventors:
• **NISHIKAWA, Koichi**
  **Tokyo 135-0061 (JP)**
• **SAKAMOTO, Eisuke**
  **Tokyo 135-0061 (JP)**
• **MIURA, Tsuyoshi**
  **Tokyo 135-0061 (JP)**

(74) Representative: **Wilson Gunn**
**Centurion House**
**129 Deansgate**
**Manchester M3 3WR (GB)**

(54) **SEMICONDUCTOR WAFER, SEMICONDUCTOR WAFER GROUP, AND SEMICONDUCTOR DEVICE**

(57)   To shorten a carrier lifetime in an epitaxial layer. A technical idea of the present disclosure is that a carrier lifetime distribution including, as an element, a carrier lifetime in an epitaxial layer measured at a plurality of measurement points has the following features. (1) In a case in which the average value of the carrier lifetime is defined as $\tau_m$, $\tau_m \leq 0.4$ μs is satisfied. (2) In a case in which the standard deviation of the carrier lifetime distribution is defined as $\sigma_\tau$, $\sigma_\tau \leq 0.5 \tau_m$ is satisfied.

*FIG. 1*

# EP 4 783 810 A1

**Description**

CROSS-REFERENCE TO RELATED APPLICATIONS

The disclosures of Japanese Patent Application No. 2025-011533 filed on January 27, 2025 and Japanese Patent Application No. 2025-185113 filed on October 31, 2025 including the specifications, drawings and abstracts are incorporated herein by reference in its entirety.

BACKGROUND

The present disclosure relates to a semiconductor wafer, a semiconductor wafer group, and a semiconductor device. The present disclosure relates to, for example, a semiconductor wafer, a semiconductor wafer group, and a semiconductor device in which an epitaxial layer is formed on a silicon carbide substrate having a 4H-SiC crystal structure.

Japanese Patent No. 7113882 (Patent Document 1) and Japanese Patent No. 7298294 (Patent Document 2) describe techniques for reducing a conduction loss at the time of ON in an insulated gate bipolar transistor (IGBT) having a withstand voltage of 10 kV or more.

Specifically, Patent Document 1 and Patent Document 2 describe a technique for increasing a carrier lifetime in an epitaxial layer in order to reduce a conduction loss.

In Seiji Ishikawa, et al., "Electrical property of 1.2 kV-class SiC Trench MOSFETs on Bonded Substrates", the Japan Society of Applied Physics Advanced Power Semiconductors Division (2023) IIB-21, a technique for shortening a carrier lifetime is described.

SUMMARY

In one power metal oxide semiconductor field effect transistor (MOSFET), current flows in the ON state, but voltage is hardly applied. Meanwhile, in the OFF state, current hardly flows, but voltage is applied. Therefore, when the power MOSFET is in the ON state, the voltage is small. Meanwhile, when the power MOSFET is in the OFF state, the current is small. Therefore, power generated in the steady state such as the ON state or the OFF state is small. This is because power is expressed by a product of current and voltage. That is, the voltage is small in the ON state, and the current is small in the OFF state. Accordingly, the product of the current and the voltage decreases in both the ON state and the OFF state. On the other hand, during the switching operation of the power MOSFET, a power loss larger than that in the ON state or the OFF state occurs.

This point will be described below. An operation of switching between the ON state and the OFF state of the power MOSFET by changing a gate voltage of the power MOSFET is referred to as a switching operation. The power MOSFET during the switching operation consumes a large amount of power because a high voltage and a large current are simultaneously generated. This power consumption is referred to as a switching loss.

The higher the switching frequency defined by a frequency of an ON/OFF signal of the power MOSFET, the better the output quality of an inverter which is one of the application targets. Meanwhile, when the switching frequency increases, the switching loss generated per unit time increases, so that the switching loss increases. For this reason, it is desired to reduce the switching loss.

Therefore, an object of the present disclosure is to reduce the switching loss of a semiconductor device.

A semiconductor wafer according to an embodiment includes a silicon carbide substrate having a crystal structure of 4H-SiC and an epitaxial layer formed on the silicon carbide substrate. In a carrier lifetime distribution including, as an element, a carrier lifetime in the epitaxial layer measured at a plurality of measurement points, in a case in which an average value of the carrier lifetime is defined as $\tau_m$, $\tau_m \leq 0.4$ $\mu$s is satisfied, and in a case in which a standard deviation of the carrier lifetime distribution is defined as $\sigma_\tau$, $\sigma_\tau \leq 0.5$ $\tau_m$ is satisfied.

A semiconductor wafer according to an embodiment includes a silicon carbide substrate having a crystal structure of 4H-SiC and an epitaxial layer formed on the silicon carbide substrate. In a carrier lifetime distribution including, as an element, a carrier lifetime in the epitaxial layer measured at a plurality of measurement points, in a case in which an average value of the carrier lifetime is defined as $\tau_m$, $\tau_m \leq 0.2$ $\mu$s is satisfied, and in a case in which a standard deviation of the carrier lifetime distribution is defined as $\sigma_\tau$, $\sigma_\tau \leq 0.05$ $\tau_m$ is satisfied.

A semiconductor device according to an embodiment includes a silicon carbide substrate having a crystal structure of 4H-SiC and an epitaxial layer formed on the silicon carbide substrate. In a carrier lifetime distribution including, as an element, a carrier lifetime in the epitaxial layer measured at a plurality of measurement points, in a case in which an average value of the carrier lifetime is defined as $\tau_m$, $\tau_m \leq 0.4$ $\mu$s is satisfied, and in a case in which a standard deviation of the carrier lifetime distribution is defined as $\sigma_\tau$, $\sigma_\tau \leq 0.5$ $\tau_m$ is satisfied.

A semiconductor device according to an embodiment includes a silicon carbide substrate having a crystal structure of 4H-SiC and an epitaxial layer formed on the silicon carbide substrate. In a carrier lifetime distribution including, as an element, a carrier lifetime in the epitaxial layer measured at a plurality of measurement points, in a case in which an average value of the carrier lifetime is defined as $\tau_m$, $\tau_m \leq 0.2$ µs is satisfied, and in a case in which a standard deviation of the carrier lifetime distribution is defined as $\sigma_\tau$, $\sigma_\tau \leq 0.05 \, \tau_m$ is satisfied.

According to one embodiment, a carrier lifetime in an epitaxial layer can be shortened in a semiconductor wafer. As a result, a switching loss of a semiconductor device manufactured using the semiconductor wafer can be reduced.

BRIEF DESCRIPTION OF THE DRAWINGS

FIG. 1 is a diagram illustrating a circuit configuration of a step-down type DC/DC converter.
FIG. 2 is a diagram illustrating a timing chart of a high-side MOSFET and a low-side MOSFET.
FIG. 3 is a diagram illustrating a configuration of a motor circuit including an inverter and a three-phase brushless motor.
FIG. 4 is a cross-sectional view illustrating a semiconductor device including a power MOSFET.
FIG. 5 is a diagram illustrating a voltage waveform, a current waveform, and a power loss waveform during a switching operation of one power MOSFET used for a switching element in association with each other.
FIG. 6 is a plan view illustrating a semiconductor wafer according to a first embodiment.
FIG. 7 is a cross-sectional view illustrating the semiconductor wafer according to the first embodiment.
FIG. 8A is a diagram for explaining that a carrier lifetime can be shortened and variations can be reduced by containing hydrogen chloride in a carrier gas.
FIG. 8B is a diagram for explaining that a carrier lifetime can be shortened and variations can be reduced by containing hydrogen chloride in a carrier gas.
FIG. 8C is a diagram for explaining that a carrier lifetime can be shortened and variations can be reduced by containing hydrogen chloride in a carrier gas.
FIG. 8D is a diagram for explaining that a carrier lifetime can be shortened and variations can be reduced by containing hydrogen chloride in a carrier gas.
FIG. 9 is a diagram illustrating a schematic configuration of an epitaxial growth reactor according to the first embodiment.
FIG. 10 is a diagram illustrating a schematic configuration of the epitaxial growth reactor in an examination example.
FIG. 11 is a diagram illustrating a carrier lifetime distribution acquired from a carrier lifetime in an epitaxial layer measured at a plurality of measurement points.
FIG. 12 is a diagram illustrating a Weibull distribution based on FIG. 11.
FIG. 13 is a diagram illustrating a carrier lifetime distribution acquired from a carrier lifetime in an epitaxial layer measured at a plurality of measurement points.
FIG. 14 is a diagram illustrating a Weibull distribution based on FIG. 13.
FIG. 15 is a cross-sectional view illustrating a manufacturing process of a semiconductor device according to a second embodiment.
FIG. 16 is a cross-sectional view illustrating a semiconductor device according to a third embodiment.

DETAILED DESCRIPTION

In all the drawings for describing the embodiments, the same members will be denoted by the same reference numerals in principle, and repeated description thereof will be omitted. Note that hatching may be applied even in a plan view for easy understanding of the drawings.

First, a power conversion circuit using a power transistor will be described. Examples of the power conversion circuit include a DC/DC converter and an inverter. Hereinafter, a DC/DC converter and an inverter will be described as examples of the power conversion circuit.

<Configuration of DC/DC Converter>

Examples of the DC/DC converter include a step-down type DC/DC converter and a step-up type DC/DC converter. Here, the step-down type DC/DC converter will be described.

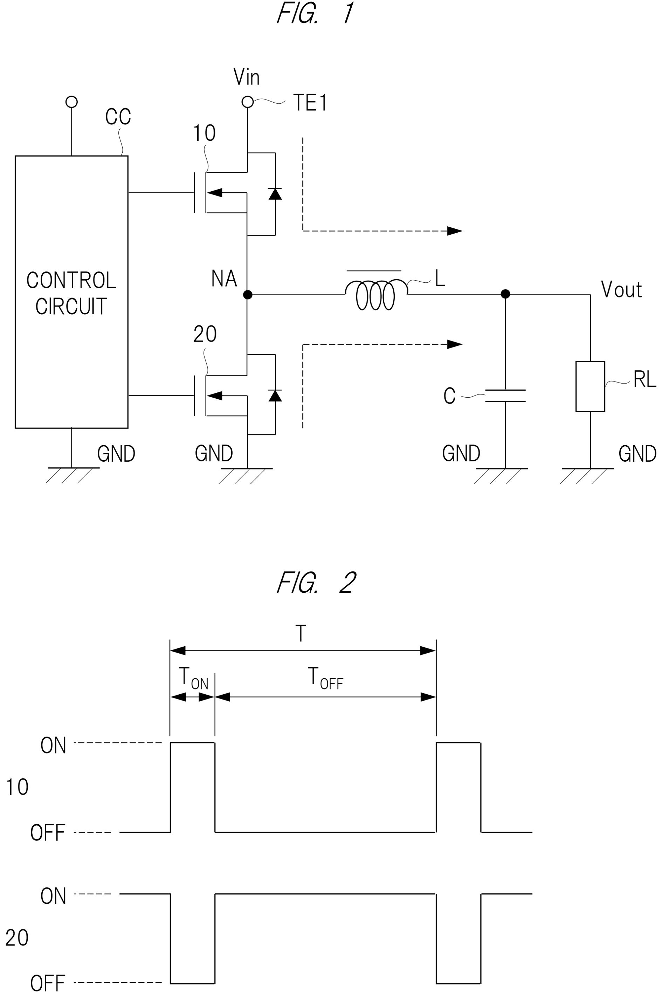

FIG. 1 is a diagram illustrating a circuit configuration of the step-down type DC/DC converter.

The step-down type DC/DC converter includes a control circuit CC, a high-side MOSFET 10, a low-side MOSFET 20, an inductor L, and a capacitor C. Each of the high-side MOSFET 10 and the low-side MOSFET 20 is a power MOSFET. The power MOSFET is one of the power transistors.

In the step-down type DC/DC converter, the high-side MOSFET 10 and the low-side MOSFET 20 are connected in series between an input terminal TE1 and a ground (reference potential) GND. The inductor L and a load RL are connected in series between a node NA between the high-side MOSFET 10 and the low-side MOSFET 20 and the ground GND connected to the load RL. The capacitor C is connected in parallel with the load RL.

A gate electrode of the high-side MOSFET 10 is connected to the control circuit CC. The gate electrode of the low-side MOSFET 20 is also connected to the control circuit CC. The control circuit CC controls ON/OFF operation of the high-side MOSFET 10. In addition, the control circuit CC controls ON/OFF operation of the low-side MOSFET 20.

Specifically, when turning on the high-side MOSFET 10, the control circuit CC turns off the low-side MOSFET 20. On the other hand, when turning off the high-side MOSFET 10, the control circuit CC turns on the low-side MOSFET 20.

For example, in a case in which the high-side MOSFET 10 is turned on and the low-side MOSFET 20 is turned off, current flows from the input terminal TE1 to the load RL via the high-side MOSFET 10 and the inductor L. Thereafter, when the high-side MOSFET 10 is turned off and the low-side MOSFET 20 is turned on, the high-side MOSFET 10 is first turned off. Thus, the current flowing from the input terminal TE1 to the load RL via the high-side MOSFET 10 and the inductor L is cut off. That is, the current flowing through the inductor L is cut off. However, in the inductor L, when the current decreases (is cut off), the current flowing through the inductor L is maintained. At this time, since the low-side MOSFET 20 is turned on, current flows from the ground GND to the load RL via the low-side MOSFET 20 and the inductor L. Thereafter, the high-side MOSFET 10 is turned on again, and the low-side MOSFET 20 is turned off.

The switching operation of the high-side MOSFET 10 and the switching operation of the low-side MOSFET 20 are repeated. As a result, in the step-down type DC/DC converter, when an input voltage Vin is input to the input terminal TE1, an output voltage Vout lower than the input voltage Vin is output to both ends of the load RL. That is, the step-down type DC/DC converter outputs the output voltage Vout lower than the input voltage Vin by the switching operation.

Hereinafter, the reason why the output voltage Vout lower than the input voltage Vin is output to both ends of the load RL in a case in which the input voltage Vin is input to the input terminal TE1 by repeating the above-described switching operation will be described.

In the following description, it is assumed that the current flowing through the inductor L is not intermittent.

The high-side MOSFET 10 performs the switching operation in an ON period $T_{ON}$ and an OFF period $T_{OFF}$ under the control of the control circuit CC. A switching frequency in this switching operation is $f = 1/(T_{ON} + T_{OFF})$.

For example, in FIG. 1, the capacitor C has a function of not significantly changing the output voltage Vout in a short time. That is, in the step-down type DC/DC converter, the capacitor C having a relatively large capacitance value is inserted in parallel with the load RL. Therefore, in the steady state, ripple voltage included in the output voltage Vout is a smaller value than the output voltage Vout. Therefore, fluctuation of the output voltage Vout within one cycle of the switching operation can be ignored.

First, a case in which the high-side MOSFET 10 is turned on is considered.

Since it is assumed that the output voltage Vout does not vary within one period, the voltage across the inductor L can be considered constant at (Vin-Vout). As a result, when the inductance of the inductor L is defined as L1, an increment $\Delta I_{ON}$ of the current in the ON period $T_{ON}$ is given by (Mathematical Formula 1).

$$\Delta I_{ON} = (Vin - Vout)/L1 \times T_{ON} \quad \cdots \text{(Mathematical Formula 1)}$$

Next, a case in which the high-side MOSFET 10 is turned off will be considered.

In this case, the low-side MOSFET 20 is turned on. Thus, the voltage applied to the inductor L is 0 - Vout = -Vout. Therefore, an increment $\Delta I_{OFF}$ of the current in the OFF period $T_{OFF}$ is given by (Mathematical Formula 2).

$$\Delta I_{OFF} = -Vout/L1 \times T_{OFF} \quad \cdots \text{(Mathematical Formula 2)}$$

In the steady state, the current flowing through the inductor L does not increase or decrease during one cycle of the switching operation. In other words, in a case in which the current flowing through the inductor L increases or decreases during one cycle, the steady state has not yet been reached. Therefore, (Mathematical Formula 3) is established in the steady state.

$$\Delta I_{ON} + \Delta I_{OFF} = 0 \quad \cdots \text{(Mathematical Formula 3)}$$

When (Mathematical Formula 1) and (Mathematical Formula 2) are substituted into (Mathematical Formula 3), (Mathematical Formula 4) is obtained.

$$Vout = Vin \times T_{ON}/(T_{ON} + T_{OFF}) \quad \cdots \text{(Mathematical Formula 4)}$$

In (Mathematical Formula 4), $T_{ON} \geq 0$ and $T_{OFF} \geq 0$. Thus, Vout < Vin is satisfied. That is, the step-down type DC/DC converter is a circuit that outputs the output voltage Vout lower than the input voltage Vin.

The ON period $T_{ON}$ and the OFF period $T_{OFF}$ are changed by controlling the switching operation by the control circuit CC based on (Mathematical Formula 4). As a result, any output voltage Vout lower than the input voltage Vin is obtained. In particular, when the ON period $T_{ON}$ and the OFF period $T_{OFF}$ are controlled to be constant, the constant output voltage Vout can be obtained.

As described above, in the step-down type DC/DC converter, the control circuit CC controls the ON/OFF operation (switching operation) of the high-side MOSFET 10 and the ON/OFF operation (switching operation) of the low-side MOSFET 20. As a result, the step-down type DC/DC converter can output the output voltage Vout lower than the input voltage Vin.

FIG. 2 is a diagram illustrating a timing chart of the high-side MOSFET 10 and the low-side MOSFET 20. The ON period $T_{ON}$ indicates a time during which the high-side MOSFET 10 is turned on. The OFF period $T_{OFF}$ indicates a time during which the high-side MOSFET 10 is turned off. In a case in which the high-side MOSFET 10 is turned on, the low-side MOSFET 20 is turned off. In a case in which the high-side MOSFET 10 is turned off, the low-side MOSFET 20 is turned on. Therefore, the ON period $T_{ON}$ indicates a time during which the low-side MOSFET 20 is turned off. The OFF period $T_{OFF}$ indicates a time during which the low-side MOSFET 20 is turned on.

As described above, the step-down type DC/DC converter is one of the switching converters that use the switching operation of each of the high-side MOSFET 10 and the low-side MOSFET 20. For example, the switching frequency of the step-down type DC/DC converter is about 100 kHz. Therefore, in order to reduce the power loss of the step-down type DC/DC converter, it is important to reduce the switching loss caused by the switching operation.

<Configuration of Inverter>

Hereinafter, a three-phase inverter will be described as an example of an inverter.

The inverter has a function of converting direct current power into alternating current power.

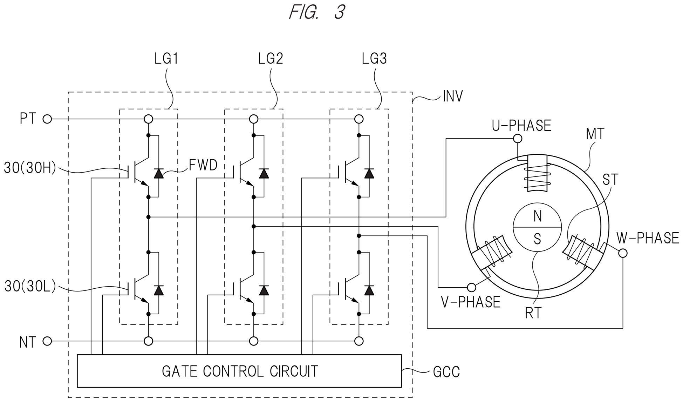

FIG. 3 is a diagram illustrating a configuration of a motor circuit including an inverter and a three-phase brushless motor. The motor circuit includes a three-phase brushless motor MT and an inverter INV. The three-phase brushless motor MT is driven by three-phase voltages having different phases. Specifically, in the three-phase brushless motor MT, a rotating magnetic field is generated inside a stator ST, which is a soft magnetic material, by using three-phase alternating currents called a U-phase, a V-phase, and a W-phase, the phases of which are shifted by 120 degrees. In this case, the magnetic field rotates around a rotor RT. As a result, a magnetic flux crossing the rotor RT, which is a conductor, changes. As a result, magnetic force is applied to the rotor RT, and the rotor RT rotates. As described above, in the three-phase brushless motor MT, the rotor RT can be rotated by using the three-phase alternating current. That is, the three-phase brushless motor MT requires three-phase alternating current. Therefore, in the motor circuit, three-phase alternating current is supplied to the three-phase brushless motor by using the inverter INV that generates alternating current from direct current.

Hereinafter, a configuration example of the inverter INV will be described.

As illustrated in FIG. 3, for example, the inverter INV includes a switching element 30 and a diode FWD corresponding to three phases. The switching element 30 and the diode FWD are connected in anti-parallel. In FIG. 3, an upper arm and a lower arm of a first leg LG1 include a configuration in which the switching element 30 and the diode FWD are connected in anti-parallel. An upper arm and a lower arm of a second leg LG2 have a configuration in which the switching element 30 and the diode FWD are connected in anti-parallel. An upper arm and a lower arm of a third leg LG3 have a configuration in which the switching element 30 and the diode FWD are connected in anti-parallel. The diode FWD connected in anti-parallel with the switching element 30 is a freewheel diode.

As described above, the inverter INV has a configuration in which the switching element 30 and the diode FWD are connected in anti-parallel between a positive potential terminal PT and each phase (U-phase, V-phase, W-phase) of the three-phase brushless motor MT. The inverter INV has a configuration in which the switching element 30 and the diode FWD are connected in anti-parallel between each phase of the three-phase brushless motor MT and a negative potential terminal NT. That is, two switching elements 30 and two diodes FWD are provided for each single phase. Therefore, six switching elements 30 and six diodes FWD are provided in three phases. A gate control circuit GCC is connected to a gate electrode of each switching element 30. The gate control circuit GCC controls the switching operation of the switching element 30. The inverter INV configured as described above controls the switching operation of the switching element 30 by the gate control circuit GCC. As a result, the inverter INV can convert direct current power into three-phase alternating current power. The three-phase alternating current power converted by the inverter INV is supplied to the three-phase brushless motor MT.

As described above, the inverter INV converts direct current power into alternating current power by controlling the switching operation of each of the six switching elements 30. For example, the switching frequency of the inverter INV is about 5 kHz or more and 20 kHz or less. Therefore, in order to reduce the power loss of the inverter INV, it is important to reduce the switching loss caused by the switching operation.

In particular, the higher the switching frequency, the better the output quality of the inverter INV. Furthermore, as a measure against noise of the inverter INV, it has been considered to operate the inverter INV at about 20 kHz exceeding a human audible frequency.

However, when the switching frequency increases, the number of switching losses generated per unit time increases, so that the switching loss increases. For this reason, it is also desired to reduce the switching loss in the inverter INV.

The switching element 30 used for the inverter INV is a power transistor. Examples of the power transistor include a power MOSFET and an IGBT.

In the present specification, the power MOSFET is assumed as a power transistor used in a DC/DC converter or an inverter.

Hereinafter, the configuration of the power MOSFET will be described.

<Configuration of Power MOSFET>

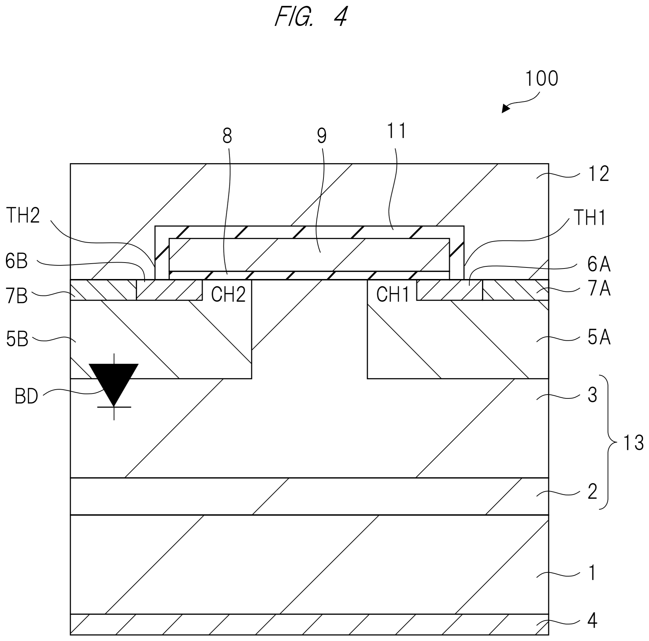

FIG. 4 is a cross-sectional view illustrating a semiconductor device 100 including the power MOSFET.

In FIG. 4, the semiconductor device 100 includes a silicon carbide substrate 1, a buffer layer 2, a drift layer 3, a drain electrode 4, a p-type well 5A, a p-type well 5B, a source region 6A, a source region 6B, a body contact region 7A, a body contact region 7B, a gate insulating film 8, a gate electrode 9, an interlayer insulating film 11, a source electrode 12, an epitaxial layer 13, a channel formation region CH1, and a channel formation region CH2.

The silicon carbide substrate 1 contains nitrogen of about $1 \times 10^{19}$ cm$^{-3}$. The thickness of the silicon carbide substrate 1 is about 50 $\mu$m or more and 500 $\mu$m or less. In a representative example, the thickness of the silicon carbide substrate 1 is about 150 $\mu$m.

The silicon carbide substrate 1 has an upper surface and a lower surface. The drain electrode 4 is formed on the lower surface of the silicon carbide substrate 1. Meanwhile, the buffer layer 2 is formed on the upper surface of the silicon carbide substrate 1.

The drift layer 3 is formed on the buffer layer 2. The buffer layer 2 and the drift layer 3 constitute the epitaxial layer 13. The epitaxial layer 13 contains nitrogen of about $1 \times 10^{15}$ cm$^{-3}$ or more and $3 \times 10^{18}$ cm$^{-3}$ or less. The epitaxial layer 13 has a thickness of 10 $\mu$m or more and 150 $\mu$m or less. In a representative example, the thickness of the epitaxial layer 13 is about 10 $\mu$m. The epitaxial layer 13 determines a withstand voltage in the OFF state of the power MOSFET. A typical example is a specification of a withstand voltage of 1.2 kV.

In the epitaxial layer 13, the p-type well 5A and the p-type well 5B are formed. For example, aluminum (Al), which is a p-type impurity, is introduced into the p-type well 5A and the p-type well 5B. The depth of each of the p-type well 5A and the p-type well 5B is about 1 $\mu$m. The impurity concentration of each of the p-type well 5A and the p-type well 5B is, for example, about $5 \times 10^{17}$ cm$^{-3}$.

In the p-type well 5A, the source region 6A and the body contact region 7A are formed. The source region 6A is an n-type semiconductor region. The depth of the source region 6A is about 0.1 $\mu$m. The impurity concentration of the source region 6A is about $1 \times 10^{20}$ cm$^{-3}$. Meanwhile, the body contact region 7A is a p-type semiconductor region. The body contact region 7A has an impurity concentration higher than that of the p-type well 5A. The source region 6A and the body contact region 7A are formed to be in contact with each other.

The source region 6B is an n-type semiconductor region. The depth of the source region 6B is about 0.1 $\mu$m. The impurity concentration of the source region 6B is about $1 \times 10^{20}$ cm$^{-3}$. Meanwhile, the body contact region 7B is a p-type semiconductor region. The body contact region 7B has an impurity concentration higher than that of the p-type well 5B. The source region 6B and the body contact region 7B are formed to be in contact with each other.

The gate insulating film 8 is formed on a part of the source region 6B, on the channel formation region CH2, on a part of the drift layer 3, on the channel formation region CH1, and on a part of the source region 6A. The gate insulating film 8 is, for example, a film containing a silicon oxide film as a main component. The thickness of the gate insulating film 8 is, for example, about 50 nm. Nitrogen is introduced in the vicinity of an interface between the gate insulating film and the drift layer 3 in order to improve interface characteristics.

The gate electrode 9 is formed on the gate insulating film 8. The gate electrode 9 is made of, for example, a polysilicon film containing n-type impurities at a high concentration.

In the gate length direction of the gate electrode 9, the channel formation region CH1 is formed in the p-type well 5A between the end of the p-type well 5A and the source region 6A. The channel formation region CH1 is a p-type semiconductor region, but when a gate voltage equal to or higher than a threshold voltage is applied to the gate electrode 9, the channel formation region CH1 is inverted to an n-type semiconductor and becomes a channel.

In the gate length direction of the gate electrode 9, the channel formation region CH2 is formed in the p-type well 5B between the end of the p-type well 5B and the source region 6B. Although the channel formation region CH2 is a p-type semiconductor region, if a gate voltage equal to or higher than a threshold voltage is applied to the gate electrode 9, the channel formation region CH2 becomes a channel including an inversion layer which is an n-type semiconductor.

The interlayer insulating film 11 is formed so as to cover the gate electrode 9. The source electrode 12 is formed on the body contact region 7B, a part of the source region 6B, the interlayer insulating film 11, a part of the source region 6A, and the body contact region 7A. As a result, the source region 6A and the body contact region 7A are electrically connected to each other via the source electrode 12. Therefore, the same potential is supplied to the source region 6A and the body contact region 7A. The source region 6B and the body contact region 7B are electrically connected to each other via the source electrode 12. Therefore, the same potential is supplied to the source region 6B and the body contact region 7B.

The semiconductor device 100 is configured as described above.

<Operation of Power MOSFET>

Next, the operation of the power MOSFET will be briefly described.

In FIG. 4, when a gate voltage equal to or higher than a threshold voltage is applied to the gate electrode 9, a channel including an inversion layer is formed in the channel formation region CH1 and the channel formation region CH2. As a result, electrons flow through a path of the source electrode 12 → the source region 6A → the channel formation region CH1 (inversion layer) → the drift layer 3 → the buffer layer 2 → the silicon carbide substrate 1 → the drain electrode 4. Similarly, electrons flow through a path of the source electrode 12 → the source region 6B → the channel formation region CH2 (inversion layer) → the drift layer 3 → the buffer layer 2 → the silicon carbide substrate 1 → the drain electrode 4. In this way, the power MOSFET is turned on.

In this state, when a gate voltage less than the threshold voltage is applied to the gate electrode 9, the channel including the inversion layer disappears and the flow of electrons is cut off. As a result, the power MOSFET is turned off. The power MOSFET operates as described above.

<Body Diode>

Next, a body diode present in the power MOSFET will be described.

As illustrated in FIG. 4, in the power MOSFET, a body diode BD is parasitically present between the p-type well 5B (p-type semiconductor layer) and the drift layer 3 (n-type semiconductor layer). Similarly, although not illustrated, a body diode is parasitically present between the p-type well 5A (p-type semiconductor layer) and the drift layer 3 (n-type semiconductor layer).

The body diode BD is a pn junction diode. That is, the body diode BD corresponds to a bipolar device. Therefore, a recovery loss occurs due to the body diode BD. Hereinafter, this point will be described.

For example, the semiconductor device 100 including the power MOSFET is used for an inverter. The inverter is used, for example, for driving control of a motor. In the driving control of the motor, there is a mode in which counter electromotive force is generated due to inductance included in the motor. When the counter electromotive force is generated, a positive potential is applied to the source electrode 12. Meanwhile, a negative potential is applied to the drain electrode 4. Therefore, when the positive potential is applied to the source electrode 12 by the counter electromotive force, the positive potential is applied to the anode (p-type well 5B) of the body diode BD through an electrically connected path of the source electrode 12 → the body contact region 7B → the p-type well 5B. Meanwhile, when the negative potential is applied to the drain electrode 4 by the counter electromotive force, the negative potential is applied to the cathode (drift layer 3) of the body diode BD through an electrically connected path of the drain electrode 4 → the silicon carbide substrate 1 → the buffer layer 2 → the drift layer 3.

As a result, the body diode BD is forward biased. Therefore, when the counter electromotive force is generated, a free-wheeling current flows by the forward biased body diode BD. That is, the body diode BD functions as a freewheel diode.

Thereafter, when the counter electromotive force disappears, 0 V is supplied to the source electrode 12, and the positive potential is supplied to the drain electrode 4. In this state, 0 V is applied to the anode (p-type well 5B) of the body diode BD, while the positive potential is applied to the cathode (drift layer 3) of the body diode BD. As a result, the body diode BD is reverse biased.

Therefore, when the body diode BD is reverse biased, electrons already injected into the p-type well 5B with forward bias are swept out toward the drain electrode 4. Meanwhile, holes already injected into the drift layer 3 with forward bias are swept out toward the source electrode 12. A recovery current is generated by sweeping out electrons and holes at this time. As a result, a recovery loss occurs due to the recovery current.

As described above, in a case in which the power MOSFET is used as the switching element, an external freewheel diode connected in anti-parallel with the switching element is not required. This is because the body diode BD parasitically present in the power MOSFET functions as a freewheel diode.

However, in a case in which the power MOSFET is used as the switching element, the switching loss increases due to the recovery loss generated in the body diode BD.

Hereinafter, this point will be described.

<Findings of Present Inventor>

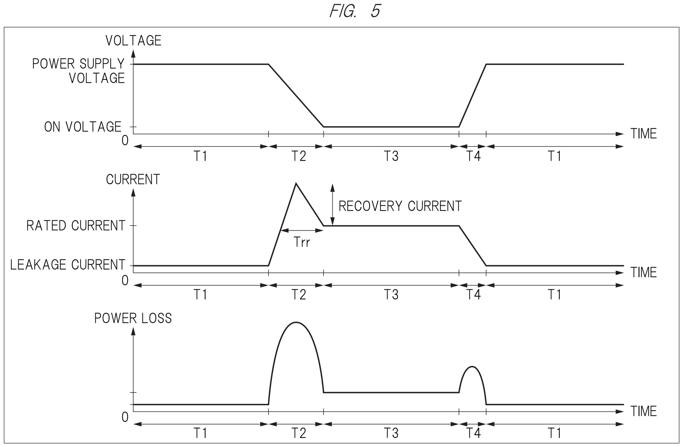

FIG. 5 is a diagram illustrating a voltage waveform, a current waveform, and a power loss waveform during a switching operation of one power MOSFET used for a switching element in association with each other.

In the voltage waveform illustrated in FIG. 5, a horizontal axis represents time. A vertical axis represents voltage. On the horizontal axis, "T1" indicates an OFF period of the power MOSFET. "T2" indicates a turn-on period of the power MOSFET. The turn-on period is a period during which the power MOSFET transitions from the OFF state to the ON state. "T3" indicates an ON period of the power MOSFET. "T4" indicates a turn-off period of the power MOSFET. The turn-off period is a period during which the power MOSFET transitions from the ON state to the OFF state.

In the current waveform illustrated in FIG. 5, a horizontal axis represents time. A vertical axis represents current. "T1", "T2", "T3", and "T4" are the same as the voltage waveform.

In the power loss waveform illustrated in FIG. 5, a horizontal axis represents time. A vertical axis represents a power loss. "T1", "T2", "T3", and "T4" are the same as the voltage waveform.

In the OFF period T1 of the power MOSFET, 0 V is applied to a source electrode, while a power supply voltage (for example, 600 V) is applied to a drain electrode. Thus, the voltage between the source electrode and the drain electrode becomes a power supply voltage.

In the OFF period T1, the power MOSFET is in the OFF state. Therefore, almost no current flows through the power MOSFET. In other words, only a minute leakage current (leakage current) flows through the power MOSFET.

As described above, in the OFF period T1, the current flowing through the power MOSFET is minute. Therefore, the power loss represented by the product of the voltage and the current is significantly small. The power loss in the OFF period T1 may be referred to as "OFF-state loss".

In the ON period T3 of the power MOSFET, the voltage applied to the source electrode and the voltage applied to the drain electrode are almost the same. For this reason, the voltage between the source electrode and the drain electrode becomes a significantly small ON voltage.

In the ON period T3, the power MOSFET is in the ON state. Therefore, a rated current flows through the power MOSFET.

As described above, in the ON period T3, the voltage between the source electrode and the drain electrode of the power MOSFET is significantly small. Therefore, the power loss represented by the product of the voltage and the current is significantly small. The power loss in the ON period T3 may be referred to as "ON-state loss".

In the turn-on period T2 of the power MOSFET, the power MOSFET transitions from the OFF state to the ON state. Therefore, the voltage between the source electrode and the drain electrode gradually decreases from the power supply voltage, and finally becomes a significantly small ON voltage. In addition, the current flowing through the power MOSFET increases from a significantly small leakage current to a rated current.

Here, a configuration in which there are a high-side MOSFET and a low-side MOSFET connected in series to each other like the DC/DC converter illustrated in FIG. 1 or the inverter illustrated in FIG. 3 is considered. For example, in FIG. 3, "30H" indicates the high-side MOSFET. "30L" indicates the low-side MOSFET. In this case, in the turn-on period T2 of the power MOSFET (high-side MOSFET 30H), the power MOSFET (low-side MOSFET 30L) is turned off. At this time, there is a mode in which a free-wheeling current flows through a body diode of the low-side MOSFET 30L to be turned off. That is, a recovery current flows through the body diode of the low-side MOSFET 30L. In other words, during the turn-on period T2 of the power MOSFET (high-side MOSFET 30H), a recovery current flows through the body diode of the low-side MOSFET 30L to be turned off. Therefore, as indicated by the current waveform, in the turn-on period T2, the recovery current flowing through the low-side MOSFET 30L is superimposed on the rated current flowing through the power MOSFET (high-side MOSFET 30H). The recovery current flows until sweeping of electrons and holes is completed. The time from the start to the end of sweeping of electrons and holes is referred to as a reverse recovery time trr. Therefore, the turn-on period T2 is limited by the reverse recovery time trr.

As described above, in the turn-on period T2, the voltage and the current increase. Therefore, the power loss during the turn-on period T2 increases. The turn-on period T2 is a period during which the switching operation of the power MOSFET is performed. Therefore, the power loss during the turn-on period T2 is a "switching loss". The switching loss during the turn-on period T2 is larger than the OFF-state loss and the ON-state loss. In particular, in the turn-on period T2, a recovery loss caused by a recovery current of the body diode is added. In addition, the turn-on period T2 is limited by the reverse recovery time trr and becomes longer. Therefore, the switching loss in the turn-on period T2 becomes significantly large.

In a turn-off period T4 of the power MOSFET, the power MOSFET (high-side MOSFET 30H) transitions from the ON state to the OFF state. Therefore, the voltage between the source electrode and the drain electrode gradually increases from a significantly small ON voltage, and finally becomes a power supply voltage. In addition, the current flowing through the power MOSFET (high-side MOSFET 30H) decreases from the rated current to a significantly small leakage current.

Here, in the turn-off period T4 of the power MOSFET (high-side MOSFET 30H), the low-side MOSFET 30L is turned on. At this time, there is a mode in which a free-wheeling current flows through a body diode of the high-side MOSFET 30H to be turned off. That is, a recovery current flows through the body diode of the high-side MOSFET 30H. In other words, during the turn-off period T4 of the power MOSFET (high-side MOSFET 30H), a recovery current flows through the body diode of the high-side MOSFET 30H which is being turned off. Therefore, in the turn-off period T4 of the high-side MOSFET 30H, the recovery current flowing through the high-side MOSFET 30H is superimposed on the rated current flowing through the low-side MOSFET 30L.

However, in FIG. 5, the waveform of the power MOSFET (high-side MOSFET 30H) is illustrated. In other words, in FIG. 5, the waveform of the low-side MOSFET 30L is not illustrated. Therefore, in the turn-off period T4 of the high-side MOSFET 30H, it is not shown that the recovery current flowing through the high-side MOSFET 30H is superimposed on the rated current flowing through the low-side MOSFET 30L. From the above description, for example, in the DC/DC converter illustrated in FIG. 1 or the inverter illustrated in FIG. 3, the switching loss increases due to the recovery loss generated in the body diode.

In particular, when the switching frequency increases, the number of switching losses generated per unit time increases, so that an increase in the switching loss becomes remarkable.

Therefore, it is desirable to reduce the recovery loss generated in the body diode.

Therefore, the technical idea of the present disclosure will be described below.

<Basic Idea>

The basic idea is to shorten a carrier lifetime in an epitaxial layer. Accordingly, it is possible to promote annihilation of carriers in the epitaxial layer. As a result, the number of carriers swept out from the epitaxial layer can be reduced. Therefore, the recovery current can be reduced. In addition, the reverse recovery time, which is the time required to sweep out the carrier, can be shortened.

As described above, according to the basic idea, the recovery loss can be reduced by reducing the recovery current and shortening the reverse recovery time. Therefore, the recovery loss, which is a part of the switching loss, can be reduced in the turn-on time of the power MOSFET. Thus, according to the basic idea, the switching loss during the turn-on period can be reduced.

The shortening of the carrier lifetime in the epitaxial layer can be achieved, for example, by forming a large number of recombination centers that cause recombination of electrons and holes in the epitaxial layer. The epitaxial layer is a layer containing silicon carbide as a component. In this case, carbon vacancy serves as a recombination center. Therefore, by forming a large number of carbon vacancies in the epitaxial layer, recombination of electrons and holes in the epitaxial layer is promoted. As a result, according to the basic idea, the carrier lifetime in the epitaxial layer can be shortened.

The formation of a large number of carbon vacancies in the epitaxial layer can be achieved, for example, by adjusting growth conditions in an epitaxial growth method. Specifically, a balance between the carbon source and the silicon source and heating conditions are adjusted. The carbon vacancy is easily formed by adopting the balance between the carbon source and the silicon source in which carbon is less than a stoichiometric ratio. In addition, a crystal of silicon carbide containing carbon vacancies has a larger entropy (disorder) than a crystal of silicon carbide without carbon vacancies. In this regard, as the temperature increases, a configuration with a large entropy is likely to be achieved. Therefore, by increasing the heating temperature in the epitaxial growth method, an epitaxial layer including a large number of carbon vacancies is easily formed.

Embodiments embodying the basic idea will be described below.

<First Embodiment>

<<Configuration of Semiconductor Wafer>>

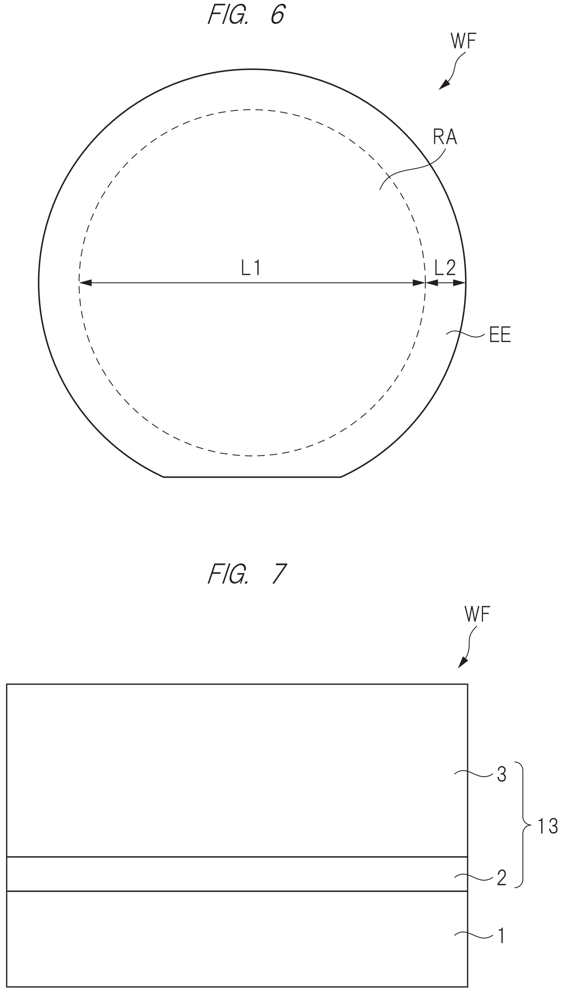

FIG. 6 is a plan view illustrating a semiconductor wafer WF according to a first embodiment.

The planar shape of the semiconductor wafer WF is a substantially circular shape. The planar size of the semiconductor wafer WF is, for example, 4 inches in diameter (about 100 mm in diameter) or more. From the viewpoint of mass productivity of the semiconductor device, the planar size of the semiconductor wafer WF is preferably 145 mm or more in diameter, and more preferably 195 mm in diameter. In particular, the semiconductor wafer WF according to the first embodiment has a planar size of 6 inches (diameter: about 150 mm).

In FIG. 6, a region EE within a length L2 from an outer peripheral portion of the semiconductor wafer WF is referred to as an edge exclusion region. The region EE is a region including a chamfered bevel. A region RA is a region surrounded by the region EE. The region RA is an inner region surrounded by a circumference having a diameter L1.

FIG. 7 is a cross-sectional view illustrating the semiconductor wafer WF according to the first embodiment.

In FIG. 7, a semiconductor wafer WF includes the silicon carbide substrate 1 and the epitaxial layer 13. The silicon carbide substrate 1 has a crystal structure of 4H-SiC. The silicon carbide substrate 1 contains, for example, nitrogen (N) which is an n-type impurity. That is, in the first embodiment, the silicon carbide substrate 1 is an n-type silicon carbide substrate. However, the technical idea of the present disclosure is not limited thereto, and can also be applied to a semiconductor device in which the silicon carbide substrate 1 is a p-type silicon carbide substrate and the p-type silicon carbide substrate is used. That is, the technical idea of the present disclosure can be widely applied to semiconductor devices having opposite conductivity types. In this regard, in the present specification, the description will be made assuming that the silicon carbide substrate 1 is an n-type silicon carbide substrate.

The concentration of nitrogen introduced into the silicon carbide substrate 1 is about $1 \times 10^{19}$ cm$^{-3}$. The thickness of the silicon carbide substrate 1 is, for example, 50 $\mu$m or more and 500 $\mu$m or less. A typical example of the thickness of the silicon carbide substrate 1 is about 350 $\mu$m.

The epitaxial layer 13 is formed on the silicon carbide substrate 1. The epitaxial layer 13 is a layer containing silicon carbide as a semiconductor material. In the first embodiment, the epitaxial layer 13 is an n-type semiconductor layer into which an n-type impurity such as nitrogen is introduced. In the first embodiment, a large number of carbon vacancies are formed in the epitaxial layer 13. The carbon vacancy functions as a recombination center between an electron and a hole.

The epitaxial layer 13 has an impurity concentration lower than that of the silicon carbide substrate 1. The impurity concentration of the epitaxial layer 13 is, for example, $1 \times 10^{15}$ cm$^{-3}$ or more and $5 \times 10^{18}$ cm$^{-3}$ or less. A typical example of the impurity concentration of the epitaxial layer 13 is $1 \times 10^{16}$ cm$^{-3}$. The thickness of the epitaxial layer 13 is, for example, 10 $\mu$m or more and 150 $\mu$m or less. A typical example of the thickness of the epitaxial layer 13 is about 10 $\mu$m. The epitaxial layer 13 determines a withstand voltage in the OFF state of the semiconductor device. A typical specification of the semiconductor device is a specification of a withstand voltage of 1.2 kV.

The epitaxial layer 13 includes, for example, the buffer layer 2 and the drift layer 3. The buffer layer 2 is formed on the silicon carbide substrate 1. The drift layer 3 is formed on the buffer layer 2. The drift layer 3 has an impurity concentration lower than that of the buffer layer 2.

<<Method of Manufacturing Semiconductor Wafer>>

Next, a method of manufacturing the semiconductor wafer WF according to the first embodiment will be described.

The silicon carbide substrate 1 is prepared. The silicon carbide substrate 1 is, for example, an n-type substrate having a crystal structure of 4H-SiC. An n-type impurity is introduced into the silicon carbide substrate 1. The n-type impurity is, for example, nitrogen. The impurity concentration of nitrogen is, for example, $5 \times 10^{18}$ cm$^{-3}$ or more and $2 \times 10^{19}$ cm$^{-3}$ or less. The silicon carbide substrate 1 has a silicon surface (Si surface) and a carbon surface (C surface), but the upper surface of the silicon carbide substrate 1 may be either a silicon surface or a carbon surface. In the first embodiment, the upper surface of the silicon carbide substrate 1 is a silicon surface.

Subsequently, the epitaxial layer 13 is formed on the silicon carbide substrate 1. The epitaxial layer 13 includes, for example, the buffer layer 2 formed on the silicon carbide substrate 1 and the drift layer 3 formed on the buffer layer 2. The buffer layer 2 and the drift layer 3 can be formed by using, for example, an epitaxial growth method.

As described above, in the first embodiment, since the upper surface of the silicon carbide substrate 1 is a silicon surface, the epitaxial layer 13 is formed on the silicon surface.

The growth conditions in the epitaxial growth method are determined based on the following guidelines. Specifically, the guidelines include the following (1) and (2). (1) A balance between a carbon source and a silicon source is adopted in such a way that carbon is less than a stoichiometric ratio so that carbon vacancies are easily formed in a crystal of silicon carbide. (2) A high entropy state is achieved by increasing the heating temperature in the epitaxial growth method so that carbon vacancies are easily formed in the crystal of silicon carbide. Thus, the epitaxial layer 13 having a large number of carbon vacancies can be formed.

For example, nitrogen as an n-type impurity is introduced into each of the buffer layer 2 and the drift layer 3. The impurity concentration of nitrogen introduced into the drift layer 3 is lower than the impurity concentration of nitrogen introduced into the buffer layer 2. The impurity concentration of the drift layer 3 depends on the element rating. For example, the impurity concentration of the drift layer 3 is about $1 \times 10^{14}$ cm$^{-3}$ or more and $1 \times 10^{17}$ cm$^{-3}$ or less. The thickness of the drift layer 3 is, for example, about 10 $\mu$m or more and 150 $\mu$m or less. In this way, the semiconductor wafer WF according to the first embodiment can be manufactured.

An example of specific epitaxial layer manufacturing conditions based on the above-described guidelines will be described.

The epitaxial layer includes a buffer layer and a drift layer. The buffer layer and the drift layer are different in impurity concentration of a dopant (nitrogen) to be introduced, and are basically continuously formed by the same epitaxial growth reactor.

The epitaxial layer is a layer for device formation. That is, the surface of the epitaxial layer is a surface for device formation. The layer for device formation is a layer on which "heat treatment at a temperature of 1700°C or higher" or "irradiation processing of electron beam, positron beam, or helium ion" described later is not performed. The surface for device formation is a surface on which "heat treatment at a temperature of 1700°C or higher" or "irradiation processing of electron beam, positron beam, or helium ion" described later is not performed.

The manufacturing conditions in the epitaxial growth method are as follows.

(1) The ratio of carbon to silicon (C/Si ratio) is more than 1.0 and 1.7 or less.
(2) The growth temperature is 1550°C or higher and 1650°C or lower.
(3) The pressure in the chamber during growth is $1 \times 10^4$ Pa or more and $4 \times 10^4$ Pa or less.
(4) The carrier gas is a mixed gas of hydrogen and hydrogen chloride (HCl).
(5) The growth rate is 40 um/hour.
(6) The nitrogen concentration in the drift layer is $5 \times 10^{15}$ cm$^{-3}$ or more and $2 \times 10^{16}$ cm$^{-3}$ or less.
(7) The nitrogen concentration in the buffer layer is $5 \times 10^{17}$ cm$^{-3}$ or more and $8 \times 10^{18}$ cm$^{-3}$ or less.

According to such production conditions, a large number of carbon vacancies as recombination centers can be formed. As a result, the carrier lifetime can be shortened.

The semiconductor wafer manufactured in the first embodiment is sold to a device manufacturer. In order to manufacture a semiconductor device on a semiconductor wafer, a device manufacturer introduces a dopant by, for example, an ion implantation method. In the ion implantation method, since a crystal is damaged, "heat treatment at a temperature of 1700°C or higher" is performed in order to recover the crystal. Meanwhile, by adopting the first embodiment, a manufacturer that manufactures a semiconductor wafer does not need to perform "heat treatment at a temperature of 1700°C or higher".

A device manufacturer sometimes performs "irradiation processing of electron beam, positron beam, or helium ion" on a semiconductor wafer in order to shorten a carrier lifetime. In this regard, the semiconductor wafer manufactured in the first embodiment has a sufficiently short carrier lifetime. When "irradiation processing of electron beam, positron beam, or helium ion" is performed by the device manufacturer, the carrier lifetime can be further shortened.

In the first embodiment, a semiconductor wafer having a short carrier lifetime can be manufactured without performing "heat treatment at a temperature of 1700°C or higher" or "irradiation processing of electron beam, positron beam, or helium ion". That is, according to the first embodiment, it is not necessary for a manufacturer that manufactures a semiconductor wafer to perform "irradiation processing of electron beam, positron beam, or helium ion" or "heat treatment at a temperature of 1700°C or higher" in order to shorten a carrier lifetime. Therefore, the manufacturing process of the semiconductor wafer can be simplified by the manufacturer that manufactures the semiconductor wafer.

A useful point of the first embodiment is that the carrier lifetime can be sufficiently shortened without performing "heat treatment at a temperature of 1700°C or higher" or "irradiation processing of electron beam, positron beam, or helium ion". Thus, the device manufacturer can further shorten the carrier lifetime by performing the "irradiation processing of electron beam, positron beam, or helium ion". Alternatively, in a case in which the carrier lifetime implemented in the first embodiment is sufficient, the device manufacturer does not need to perform the "Irradiation processing of electron beam, positron beam, or helium ion". As a result, the manufacturing process of the semiconductor device can be simplified.

According to the epitaxial growth method under the above-described manufacturing conditions, not only the carrier lifetime can be shortened, but also variations in carrier lifetime in the semiconductor wafer can be reduced.

This point will be described below. In the epitaxial growth method, a source gas and a carrier gas are used. The source gas includes a carbon source gas and a silicon source gas. The carbon source gas is, for example, propane. The silicon source gas is, for example, silane. In the first embodiment, the carrier gas contains hydrogen and hydrogen chloride.

In order to reduce variations in carrier lifetime, the "C/Si ratio" of the supplied source gas is desirably as uniform as possible over the entire silicon carbide substrate. In the first embodiment, the variation of the "C/Si ratio" is suppressed.

In this regard, in the first embodiment, the carrier gas contains hydrogen chloride in addition to hydrogen. Hydrogen chloride has a function of suppressing deposition of silicon in a pipe used for supplying a source gas. That is, hydrogen chloride has a function of suppressing decomposition of the silicon source gas. Therefore, since hydrogen chloride is contained in the carrier gas, the silicon source gas is sufficiently supplied not to the pipe but to the semiconductor wafer without being decomposed. That is, since hydrogen chloride is contained in the carrier gas, the silicon source gas is hardly decomposed and consumed in the pipe on the upstream side of the semiconductor wafer. Therefore, the C/Si ratio is small and hardly fluctuates over the entire semiconductor wafer. As a result, according to the first embodiment, carbon vacancies are easily generated, and the carrier lifetime can be shortened and made uniform.

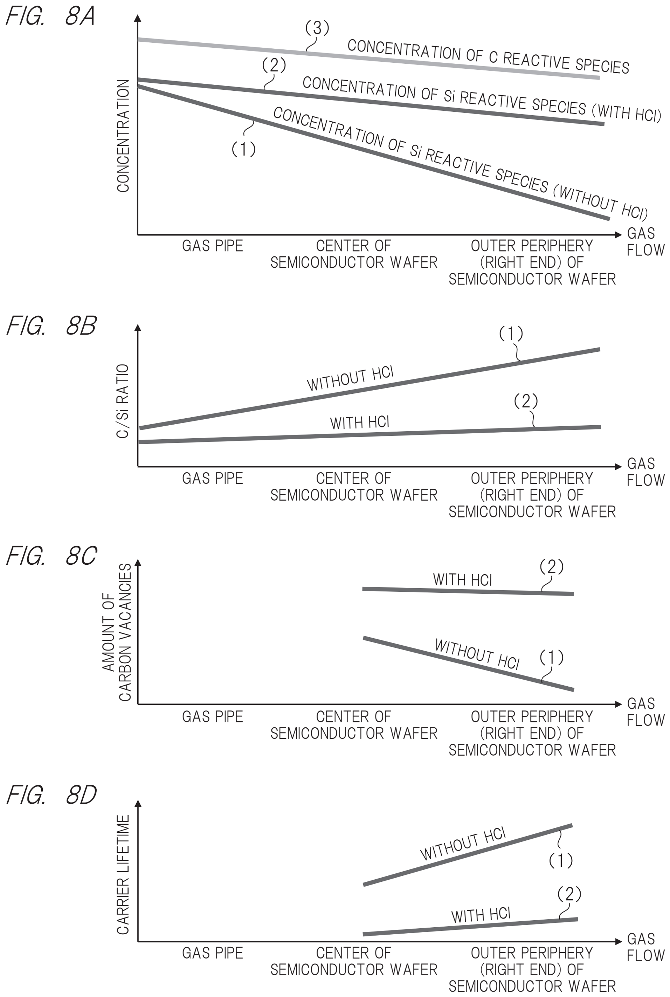

FIGS. 8A to 8D are diagrams for explaining that the carrier lifetime can be shortened and variations can be reduced by containing hydrogen chloride in the carrier gas.

FIG. 8A is a graph showing a relationship between the gas flow and the concentration of reactive species. Examples of the reactive species include carbon reactive species (C reactive species) and silicon reactive species (Si reactive species). The gas flow is gas pipe → center of semiconductor wafer → outer periphery (right end) of semiconductor wafer and outer periphery (left end) of semiconductor wafer. In FIGS. 8A to 8D, the outer periphery (left end) of the semiconductor wafer is omitted.

In FIG. 8A, a graph (1) shows a relationship between the concentration of Si reactive species and the gas flow in a case in which hydrogen chloride is not contained in the carrier gas. A graph (2) shows a relationship between the concentration of Si reactive species and the gas flow in a case in which hydrogen chloride is contained in the carrier gas. A graph (3) shows a relationship between the concentration of the C reactive species and the gas flow.

In any of the graph (1), the graph (2), and the graph (3), the concentration tends to decrease as the gas flows from upstream to downstream. This is because the gas is decomposed as the gas flows from upstream to downstream. In particular, a decrease in the concentration of the Si reactive species in a case in which hydrogen chloride is not contained in the carrier gas (graph (1)) is larger than a decrease in the concentration of the Si reactive species in a case in which hydrogen chloride is contained in the carrier gas (graph (2)). This is because the decomposition of the silicon source gas is suppressed when hydrogen chloride is contained in the carrier gas.

FIG. 8B is a graph showing a relationship between the gas flow and the "C/Si ratio". In FIG. 8B, a graph (1) shows a relationship between the "C/Si ratio" and the gas flow in a case in which hydrogen chloride is not contained in the carrier gas. A graph (2) shows a relationship between the "C/Si ratio" and the gas flow in a case in which hydrogen chloride is contained in the carrier gas. As can be seen from FIG. 8B, a change in the "C/Si ratio" in a case in which hydrogen chloride is not contained in the carrier gas (graph (1)) is larger than a change in the "C/Si ratio" in a case in which hydrogen chloride is contained in the carrier gas (graph (2)).

FIG. 8C is a graph showing a relationship between the gas flow and the amount of carbon vacancies. In FIG. 8C, a graph (1) shows a relationship between the amount of carbon vacancies and the gas flow in a case in which hydrogen chloride is not contained in the carrier gas. A graph (2) shows a relationship between the amount of carbon vacancies and the gas flow in a case in which hydrogen chloride is contained in the carrier gas.

As can be seen from FIG. 8C, the amount of carbon vacancies in a case in which hydrogen chloride is not contained in the carrier gas (graph (1)) is smaller than the amount of carbon vacancies in a case in which hydrogen chloride is contained in the carrier gas (graph (2)). Further, a change in the amount of carbon vacancies in a case in which hydrogen chloride is not contained in the carrier gas (graph (1)) is larger than a change in the amount of carbon vacancies in a case in which hydrogen chloride is contained in the carrier gas (graph (2)).

FIG. 8D is a graph showing a relationship between the gas flow and the carrier lifetime. A graph (1) shows a relationship between the carrier lifetime and the gas flow in a case in which hydrogen chloride is not contained in the carrier gas. A graph (2) shows a relationship between the carrier lifetime and the gas flow in a case in which hydrogen chloride is contained in the carrier gas.

As can be seen from FIG. 8D, a carrier lifetime (graph (1)) in a case in which hydrogen chloride is not contained in the carrier gas is larger than a carrier lifetime (graph (2)) in a case in which hydrogen chloride is contained in the carrier gas. Further, a change in the carrier lifetime in a case in which hydrogen chloride is not contained in the carrier gas (graph (1)) is larger than a change in the carrier lifetime in a case in which hydrogen chloride is contained in the carrier gas (graph (2)).

From the above, it is found that a carrier lifetime can be shortened and variations can be reduced by using a mixed gas of hydrogen and hydrogen chloride as a carrier gas.

Furthermore, in the embodiment, an epitaxial growth reactor suitable for reducing variations in carrier lifetime is adopted. The epitaxial growth reactor is a reactor that forms an epitaxial layer on an upper surface of a silicon carbide substrate. Specifically, in the first embodiment, a "vertical single wafer type epitaxial growth reactor" is used.

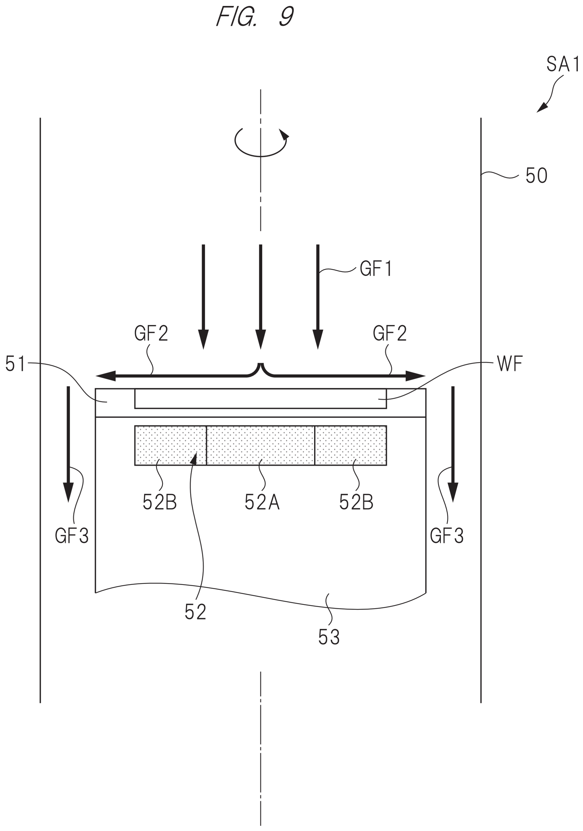

FIG. 9 is a diagram illustrating a schematic configuration of an epitaxial growth reactor SA1 according to the first embodiment. The epitaxial growth reactor SA1 is a "vertical single wafer type epitaxial growth reactor". The epitaxial growth reactor SA1 is an epitaxial growth reactor that causes a source gas to flow in the longitudinal direction. The epitaxial growth reactor SA1 is an epitaxial growth reactor that processes the semiconductor wafer WF one by one. The epitaxial growth reactor SA1 includes a housing 50, a rotating susceptor 51, a heater 52, and a fixed susceptor 53.

The housing 50 has a cylindrical shape. The rotating susceptor 51 is configured to place the semiconductor wafer WF. The rotating susceptor 51 is configured to rotate. When the rotating susceptor 51 rotates, the semiconductor wafer WF also rotates about the center. The heater 52 is embedded inside the fixed susceptor 53. The heater 52 includes a resistor. The heater 52 heats the semiconductor wafer WF using Joule heat generated by applying current to the resistor. The heater 52 includes an inner heater 52A and an outer heater 52B. The outer heater 52B has a concentric circular planar shape. The inner heater 52A is disposed within the concentric circle. The inner heater 52A and the outer heater 52B can be independently controlled. Therefore, by appropriately controlling each of the inner heater 52A and the outer heater 52B, the in-plane uniformity of the temperature of the semiconductor wafer WF can be enhanced. As a result, the uniformity of the "C/Si ratio" on the upper surface of the semiconductor wafer WF can be improved.

The source gas flows in a direction of an arrow GF1 → a direction of an arrow GF2 → a direction of an arrow GF3. The arrow GF1 indicates a flow perpendicular to the upper surface of the semiconductor wafer WF. The arrow GF1 indicates a flow descending toward the semiconductor wafer WF. The arrow GF2 indicates a flow parallel to the upper surface of the semiconductor wafer WF. The arrow GF2 indicates a flow from the center of the semiconductor wafer WF toward the outer periphery. The arrow GF3 indicates a flow parallel to the side surface of the rotating susceptor 51. The arrow GF3 indicates a downward flow along the side surface of the rotating susceptor 51.

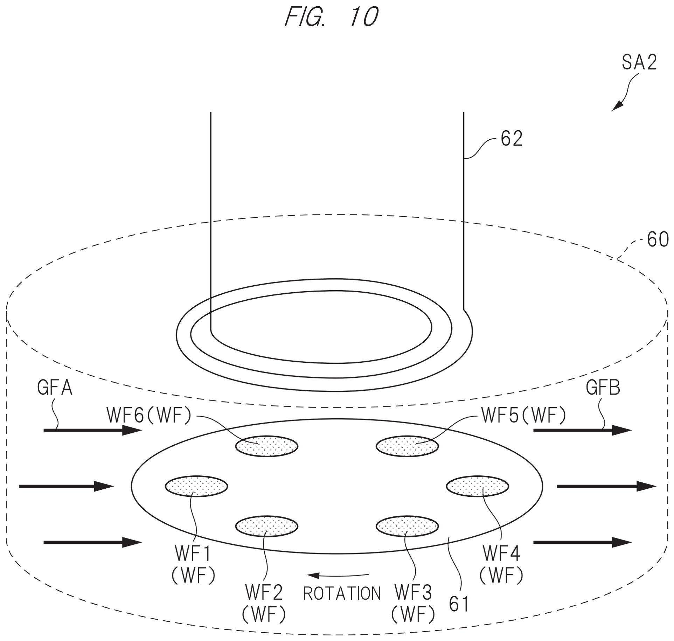

FIG. 10 is a diagram illustrating a schematic configuration of an epitaxial growth reactor SA2 in an examination example. The epitaxial growth reactor SA2 is a "horizontal batch-type epitaxial growth reactor". The epitaxial growth reactor SA2 is an epitaxial growth reactor that causes a source gas to flow in the lateral direction. The epitaxial growth reactor SA2 is an epitaxial growth reactor that simultaneously processes a plurality of semiconductor wafers WF. The plurality of semiconductor wafers WF is, for example, six semiconductor wafers WF. FIG. 10 illustrates a semiconductor wafer WF1, a semiconductor wafer WF2, a semiconductor wafer WF3, a semiconductor wafer WF4, a semiconductor wafer WF5, and a semiconductor wafer WF6.

The epitaxial growth reactor SA2 includes a housing 60, a susceptor 61, and a coil 62. The susceptor 61 is disposed inside the housing 60. Six semiconductor wafers WF are arranged on the susceptor 61. The susceptor 61 is configured to rotate. When the susceptor 61 rotates, the six semiconductor wafers WF revolve. Meanwhile, in the epitaxial growth reactor SA2, even when the susceptor 61 rotates, each of the six semiconductor wafers WF does not rotate. The coil 62 is disposed above the susceptor 61. The coil 62 is supplied with high-frequency power. As a result, the coil 62 heats the six semiconductor wafers WF disposed on the susceptor 61 by induction heating using the supplied high-frequency power.

The source gas flows along a direction of an arrow GFA → a direction of an arrow GFB. Each of the arrows GFA and GFB indicates a flow parallel to the upper surface of the semiconductor wafer WF. The source gas is supplied in the direction of the arrow GFA. On the other hand, the source gas is discharged in the direction of the arrow GFB. Attention is paid to the semiconductor wafer WF1. In FIG. 10, the susceptor 61 is rotated clockwise. For example, in a case in which the semiconductor wafer WF1 is at the "9 o'clock position" and in a case in which the semiconductor wafer WF1 is at the "3 o'clock position", the "C/Si ratio" of the source gas supplied to the semiconductor wafer WF1 significantly fluctuates. This is because the ratio of the source gas supplied at the "3 o'clock position" consumed for the growth of the epitaxial layer is larger than that of the source gas supplied at the "9 o'clock position". That is, when the ratio consumed for the growth of the epitaxial layer changes, the "C/Si ratio" of the source gas varies. Therefore, in the epitaxial growth reactor SA2, in a case in which focusing on one semiconductor wafer WF, the "C/Si ratio" of the supplied source gas significantly varies depending on the position during rotation (revolution). As a result, in the epitaxial growth reactor SA2, in a case in which focusing on one semiconductor wafer WF, variations in carrier lifetime become large.

Meanwhile, in the epitaxial growth reactor SA1, even when the rotating susceptor 51 is rotated, the semiconductor wafer WF rotates but does not revolve. Therefore, in the epitaxial growth reactor SA1, even when the rotating susceptor 51 is rotated, the variation in the "C/Si ratio" of the source gas is smaller than that in the epitaxial growth reactor SA2.

Further, the epitaxial growth reactor SA1 heats one semiconductor wafer WF by "resistance heating" by the heater 52. Meanwhile, the epitaxial growth reactor SA2 heats the plurality of semiconductor wafers WF by "induction heating" using the coil 62. In a configuration in which one semiconductor wafer WF is heated by "resistance heating", the temperature distribution in the semiconductor wafer WF can be made uniform as compared with a configuration in which a plurality of semiconductor wafers WF is heated by "induction heating".

In particular, the epitaxial growth reactor SA1 includes the inner heater 52A and the outer heater 52B that can be independently controlled. Therefore, in the epitaxial growth reactor SA1, fine control for improving the in-plane uniformity of the temperature can be performed. Therefore, from this perspective as well, the epitaxial growth reactor SA1 can enhance the in-plane uniformity of the temperature of the semiconductor wafer WF as compared with the epitaxial growth reactor SA2.

As described above, according to the first embodiment in which the epitaxial growth reactor SA1 is employed, it is possible to reduce variations in carrier lifetime as compared with a case in which the epitaxial growth reactor SA2 is employed.

In the epitaxial growth reactor SA1 illustrated in FIG. 9, as indicated by the arrow GF2, the source gas flows from the center of the semiconductor wafer WF to the outer periphery along the upper surface of the semiconductor wafer WF. Therefore, the source gas flowing through the outer periphery of the semiconductor wafer WF is consumed for the growth of the epitaxial layer at a higher rate than the source gas supplied to the center of the semiconductor wafer WF. Therefore, the "C/Si ratio" of the source gas supplied to the outer periphery of the semiconductor wafer WF1 significantly varies from the "C/Si ratio" of the source gas supplied to the center. Therefore, it is desirable not to use a region near the outer periphery (edge exclusion region) of the semiconductor wafer WF as a product region. Accordingly, it is possible to reduce variations in carrier lifetime.

<<First Feature Point in First Embodiment>>

A first feature point in the first embodiment is that the basic idea of shortening the carrier lifetime in the epitaxial layer 13 is embodied. Specifically, the first feature point is that the carrier lifetime distribution including, as an element, the carrier lifetime in the epitaxial layer 13 measured at a plurality of measurement points has the following features.

(1) In a case in which the average value of the carrier lifetime is defined as $\tau_m$, $\tau_m \leq 0.4$ $\mu$s is satisfied.
(2) In a case in which the standard deviation of the carrier lifetime distribution is defined as $\sigma_\tau$, $\sigma_\tau \leq 0.5$ $\tau_m$ is satisfied.

Hereinafter, a verification result that the above-described first feature point is achieved when the semiconductor wafer WF according to the first embodiment is manufactured will be described.

The sample of the semiconductor wafer WF is manufactured based on the above-described guideline. The planar size of the sample is 6 inches in diameter (about 150 mm in diameter). In the sample, the concentration of nitrogen introduced into the epitaxial layer is about $6.2 \times 10^{15}$ $cm^{-3}$.

A carrier lifetime $\tau$ in the epitaxial layer is measured at a plurality of measurement points in the sample. For the measurement of $\tau$, a $\mu$-microwave photoconductivity decay (PCD) method is used. The $\mu$-PCD method is a method described below. That is, pulsed laser light is irradiated onto the upper surface of the epitaxial layer. In this case, microwaves are reflected according to the concentration of electrons and holes in the epitaxial layer. For example, when the concentration of electrons and holes in the epitaxial layer is high, the reflectance of the microwave becomes high. On the other hand, when the concentration of electrons and holes in the epitaxial layer is low, the reflectance of the microwave becomes low.

Therefore, when recombination of electrons and holes occurs in the epitaxial layer, the concentration of electrons and holes becomes low. As a result, the reflectance of the microwave decreases. From this, by measuring the reflectance of the microwave with time by the $\mu$-PCD method, $\tau$ until the electrons and holes disappear indirectly by recombination can be measured.

For example, a device LTA-2000 manufactured by Kobelco Research Institute is used for measurement of $\tau$. YAG laser having a wavelength of 266 nm is used as a laser beam. The temperature of the sample when $\tau$ is measured is 25°C. The frequency of the microwave is 26 GHz.

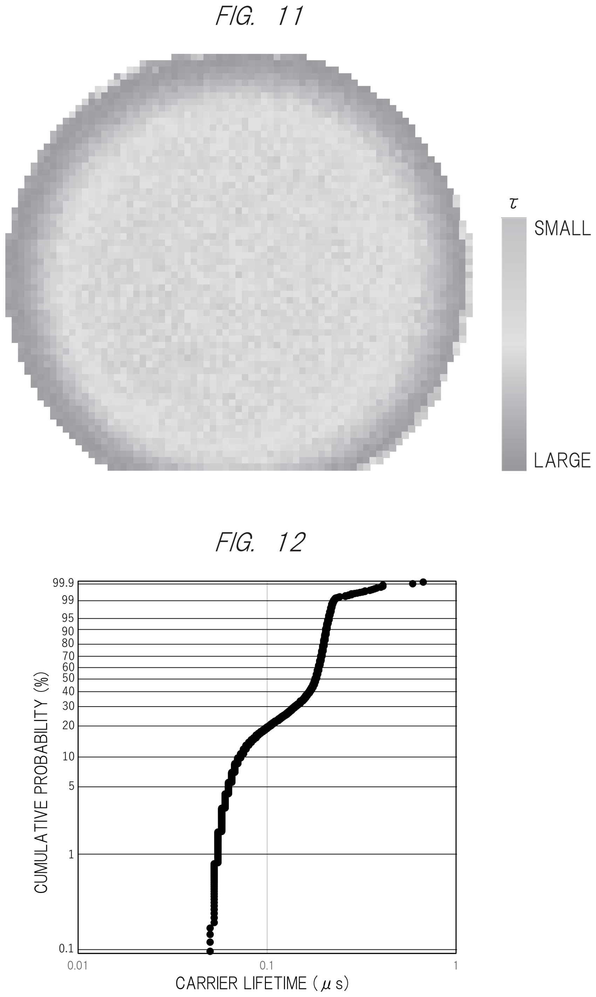

FIG. 11 is a diagram illustrating a carrier lifetime distribution acquired from the carrier lifetime $\tau$ in the epitaxial layer measured at a plurality of measurement points. This carrier lifetime distribution is a distribution based on measurement points described below. That is, L2 of the region EE illustrated in FIG. 6 is set to 2 mm. The carrier lifetime distribution is acquired using $\tau$ measured at measurement points in the region RA (length L1 is 146 mm) excluding the region EE.

Note that the carrier lifetime distribution illustrated in FIG. 11 is a concentric distribution pattern. As described above, when the concentric distribution pattern is formed, it is easy to reduce variations in carrier lifetime. That is, from the viewpoint of reducing variations in carrier lifetime, the carrier lifetime distribution is desirably a concentric distribution pattern.

FIG. 12 is a diagram illustrating a Weibull distribution based on FIG. 11. In FIG. 12, a horizontal axis represents a carrier lifetime. A vertical axis represents a cumulative probability.

The following results are obtained by analyzing FIG. 11 and FIG. 12.

Minimum value of carrier lifetime $\tau$: 0.05 $\mu$s
Maximum value of carrier lifetime $\tau$: 0.68 $\mu$s
Average value $\tau_m$ of carrier lifetime $\tau$: 0.16 $\mu$s
Standard deviation $\sigma_\tau$ of carrier lifetime distribution: 0.052 $\mu$s (here, $\sigma_\tau \leq 0.5$ $\tau_m$)
Median value $\tau_c$ of carrier lifetime $\tau$: 0.18 $\mu$s (here, $\tau_c \leq 1.5$ $\tau_m$)

From this result, the sample satisfies the first feature point. That is, it is confirmed that the first feature point can be achieved.

In addition, the carrier lifetime (0.1% percentile) at a point at which the cumulative probability reached 0.1% in the Weibull distribution was 0.05 $\mu$s or more. The carrier lifetime (99.9% percentile) at a point at which the cumulative probability reached 99.9% in the Weibull distribution was 0.68 $\mu$s or less. As a result, an inclination of the two points is $(0.999 - 0.001)/(0.68 - 0.05) = 1.58$ $\mu s^{-1}$ or more ($\mu s^{-1}$ is equivalent to $1/\mu s$). In order to reduce variations in carrier lifetime in the semiconductor wafer, an inclination between the 0.1% percentile and the 99.9% percentile in the Weibull distribution is preferably 1.5 $\mu s^{-1}$ or more.

Next, the technical significance of the first feature point will be described.

By realizing "in a case in which an average value is defined as $\tau_m$, $\tau_m \leq 0.4$ $\mu$s", the carrier lifetime in the epitaxial layer of the semiconductor wafer can be shortened. Accordingly, it is possible to promote annihilation of carriers in the epitaxial layer.

By realizing "in a case in which a standard deviation is defined as $\sigma_\tau$, $\sigma_\tau \leq 0.5$ $\tau_m$ is satisfied", variations in carrier lifetime in the epitaxial layer can be reduced. In other words, the uniformity of the carrier lifetime in the epitaxial layer can be improved.

For example, as illustrated in FIG. 1, two power MOSFETs such as the high-side MOSFET 10 and the low-side MOSFET 20 are used in the step-down type DC/DC converter. As illustrated in FIG. 3, six power MOSFETs are used in the three-phase inverter. In general, it is desirable that the plurality of power MOSFETs constituting each of the DC/DC converter and the inverter suppresses variations in characteristics. For this reason, a plurality of semiconductor chips acquired from one semiconductor wafer is often used.

However, in one semiconductor wafer as well, when variations in carrier lifetime in the epitaxial layer are large, variations in switching loss are generated. For example, in a case in which a power MOSFET having a long carrier lifetime is used for the high-side MOSFET 30H, the switching loss of the low-side MOSFET 30L increases. Similarly, in a case in which a power MOSFET having a long carrier lifetime is used for the low-side MOSFET 30L, the switching loss of the high-side MOSFET 30H increases.

An increase in switching loss means an increase in power loss. The fact that the power loss increases means that the amount of heat generated increases. Therefore, only the temperature of the power MOSFET connected in series with the power MOSFET having a long carrier lifetime may become abnormally high. As a result, the probability that the power MOSFET having an abnormally high temperature fails increases. Therefore, it is necessary to enhance cooling performance of a cooling mechanism. In this case, the cooling mechanism is increased in size.

In this regard, according to the first feature point, variations in carrier lifetime in the epitaxial layer can be reduced in one semiconductor wafer. Therefore, according to the first embodiment, it is possible to reduce variations in switching loss in the plurality of power MOSFETs constituting each of the DC/DC converter and the inverter. As a result, in the first embodiment, it is possible to suppress only the temperature of the specific power MOSFET from becoming abnormally high. Therefore, it is not necessary to enhance the cooling performance of the cooling mechanism more than necessary. Thus, according to the first embodiment, miniaturization of the cooling mechanism can be achieved.

<<Second Feature Point in First Embodiment>>

A second feature point in the first embodiment is that the basic idea of shortening the carrier lifetime in the epitaxial layer 13 is embodied. Specifically, the second feature point is that the carrier lifetime distribution including, as an element, the carrier lifetime in the epitaxial layer 13 measured at a plurality of measurement points has the following features.

(1) In a case in which the average value of the carrier lifetime is defined as $\tau_m$, $\tau_m \leq 0.2$ $\mu$s is satisfied.
(2) In a case in which the standard deviation of the carrier lifetime distribution is defined as $\sigma_\tau$, $\sigma_\tau \leq 0.05\ \tau_m$ is satisfied.

Hereinafter, a verification result that the above-described second feature point is achieved when the semiconductor wafer WF according to the first embodiment is manufactured will be described. A sample used for verification of the second feature point is the same as the sample used for verification of the first feature point. However, as will be described later, $\tau$ constituting the carrier lifetime distribution is different.

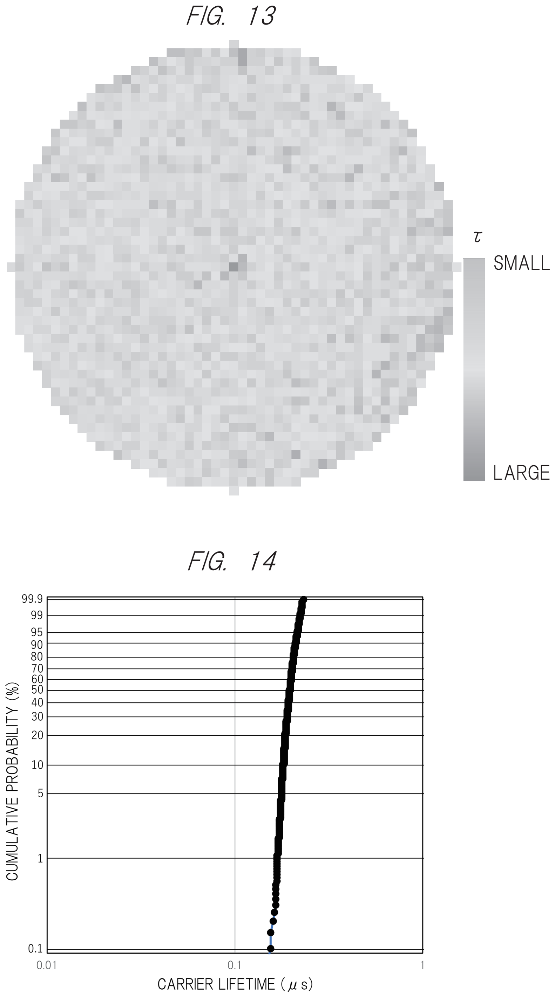

FIG. 13 is a diagram illustrating a carrier lifetime distribution acquired from the carrier lifetime $\tau$ in the epitaxial layer measured at a plurality of measurement points. This carrier lifetime distribution is a distribution based on measurement points described below. That is, L2 of the region EE illustrated in FIG. 6 is set to 25 mm. The carrier lifetime distribution is acquired using $\tau$ measured at a measurement point in the region RA (length L1 is 100 mm) excluding the region EE. This point is different from the verification of the first feature point.

Note that the carrier lifetime distribution illustrated in FIG. 13 is a radial distribution pattern when viewed from the center. As described above, when the distribution pattern is a radial distribution pattern when viewed from the center, it is easy to reduce variations in carrier lifetime. That is, from the viewpoint of reducing variations in carrier lifetime, the carrier lifetime distribution is desirably a radial distribution pattern when viewed from the center.

FIG. 14 is a diagram illustrating a Weibull distribution based on FIG. 13. In FIG. 14, a horizontal axis represents a carrier lifetime. A vertical axis represents a cumulative probability. In FIG. 14, the inclination is steeper than that in FIG. 12. In the Weibull distribution, the steeper the inclination, the smaller the variation.

The carrier lifetime (0.1% percentile) at a point at which the cumulative probability reached 0.1% in the Weibull distribution was 0.15 $\mu$s or more. The carrier lifetime (99.9% percentile) at a point at which the cumulative probability reached 99.9% in the Weibull distribution was 0.24 $\mu$s or less. As a result, an inclination of the two points is (0.999 - 0.001)/(0.24 - 0.15) = 11.09 $\mu$s$^{-1}$ or more ($\mu$s$^{-1}$ is equivalent to 1/$\mu$s). In order to reduce variations in carrier lifetime in the semiconductor wafer, an inclination between the 0.1% percentile and the 99.9% percentile in the Weibull distribution is preferably 11.0 $\mu$s$^{-1}$ or more. Therefore, the variation in $\tau$ in FIG. 14 is smaller than that in FIG. 12.

The following results are obtained by analyzing FIG. 13 and FIG. 14.

Minimum value of carrier lifetime $\tau$: 0.15 $\mu$s

Maximum value of carrier lifetime $\tau$: 0.24 $\mu$s
Average value $\tau_m$ of carrier lifetime $\tau$: 0.196 $\mu$s
Standard deviation $\sigma_\tau$ of carrier lifetime distribution: 0.012 $\mu$s (here, $\sigma_\tau \leq 0.5\ \tau_m$)
Median value $\tau_c$ of carrier lifetime $\tau$: 0.20 $\mu$s (here, $\tau_c \leq 1.5\ t_n$)

From this result, the sample satisfies the second feature point. That is, it is confirmed that the second feature point can be achieved.

The following knowledge is obtained in consideration of the carrier lifetime distribution in FIG. 11 satisfying the first feature point and the carrier lifetime distribution in FIG. 13 satisfying the second feature point.

This indicates that the semiconductor wafer of the first embodiment is more uniform as it is closer to the center of the substrate. In particular, in the case of a semiconductor wafer including the second feature point within a range within a radius of 50 mm from the center of the substrate, it is possible to provide a semiconductor device in which variation in performance between products is reduced by manufacturing the semiconductor device by adopting the semiconductor wafer.

<<Third Feature Point in First Embodiment>>

As described above, desirably, the plurality of power MOSFETs serving as components of the DC/DC converter or the inverter has small variations in carrier lifetime. Therefore, desirably, the variation in carrier lifetime is small in one semiconductor wafer from which the plurality of power MOSFETs is acquired. In this regard, if the first feature point or the second feature point is achieved, the variation in carrier lifetime can be reduced in one semiconductor wafer. As a result, variations in characteristics of the plurality of power MOSFETs can be suppressed. Therefore, the performance of the DC/DC converter or the inverter can be improved.

Further, desirably, variations among a plurality of products constituting the DC/DC converter or the inverter are also small. This is because it is desirable that a plurality of products has uniform performance. In this regard, for example, it is assumed that a plurality of power MOSFETs acquired from a first semiconductor wafer is used as a first product among the plurality of products. In addition, it is assumed that a plurality of power MOSFETs acquired from a second semiconductor wafer is used as a second product among the plurality of products. In this case, in order to make the performance of the first product and the second product uniform, it is desirable to reduce variations in carrier lifetime between the first product and the second product. That is, desirably, the variation in carrier lifetime is small between the first semiconductor wafer and the second semiconductor wafer. Application of the first embodiment can suppress variations in carrier lifetime among the plurality of semiconductor wafers.

Specifically, the third feature point in the first embodiment is that in a semiconductor wafer group including a plurality of semiconductor wafers, in a case in which standard deviation is defined as $\sigma_{st}$ in an average value distribution including, as an element, an average value $\tau_m$ of the carrier lifetimes of the semiconductor wafers included in the semiconductor wafer group, $\sigma_{st} \leq 0.2\ \mu$s is satisfied. More specifically, when the semiconductor wafer group includes 25 semiconductor wafers, $\sigma_{st} \leq 0.1\ \mu$s.

Accordingly, it is possible to reduce variations in carrier lifetime in the semiconductor wafer group. Therefore, it is possible to reduce variations in performance among a plurality of products.

<<Fourth Feature Point in First Embodiment>>

A fourth feature point in the first embodiment is that the average value of the carrier lifetime and the standard deviation of the carrier lifetime distribution are reduced in the semiconductor wafer having a diameter of 6 inches. In recent years, semiconductor wafers having a planar size of 6 inches or more in diameter have started to be used. In a semiconductor wafer having a planar size of 6 inches or more in diameter, improving the uniformity of the carrier lifetime is more difficult than improving the uniformity of the carrier lifetime in a semiconductor wafer having a planar size of 4 inches in diameter. In this regard, the first embodiment achieves reduction of the average value of the carrier lifetime and the standard deviation of the carrier lifetime distribution in the semiconductor wafer having a planar size of 6 inches in diameter. For this reason, the first embodiment has a great technical significance in that it overcomes a problem with high difficulty.

<Second Embodiment>

<<Configuration of Semiconductor Device>>

In a second embodiment, an example of a semiconductor device manufactured using the semiconductor wafer WF in the first embodiment will be described. The semiconductor device according to the second embodiment is a semiconductor device including the power MOSFET. Specifically, the semiconductor device according to the second embodiment basically has a configuration similar to that of the semiconductor device 100 illustrated in FIG. 4. The semiconductor device according to the second embodiment is used for a power conversion circuit such as a DC/DC converter or an inverter.

The semiconductor device according to the second embodiment is manufactured using the semiconductor wafer WF according to the first embodiment. Therefore, in the second embodiment, the carrier lifetime distribution including, as an element, the carrier lifetime in the epitaxial layer 13 measured at a plurality of measurement points has the first feature point or the second feature point described above. That is, in the second embodiment, the carrier lifetime in the epitaxial layer 13 can be shortened.

Accordingly, it is possible to promote annihilation of carriers in the epitaxial layer 13. Therefore, according to the second embodiment, the number of carriers swept out from the epitaxial layer 13 can be reduced. Therefore, the recovery current of the body diode parasitically present in the power MOSFET can be reduced. In addition, the reverse recovery time of the body diode can be shortened.

As described above, according to the second embodiment, the recovery loss can be reduced by reducing the recovery current and shortening the reverse recovery time. Accordingly, it is possible to reduce the recovery loss, which is a part of the switching loss, in the turn-on time of the power MOSFET. As a result, according to the second embodiment, the switching loss during the turn-on period can be reduced.

<<Method of Manufacturing Semiconductor Device>>

Next, a method of manufacturing the semiconductor device according to the second embodiment will be described.

First, the semiconductor wafer WF manufactured in the first embodiment is prepared.

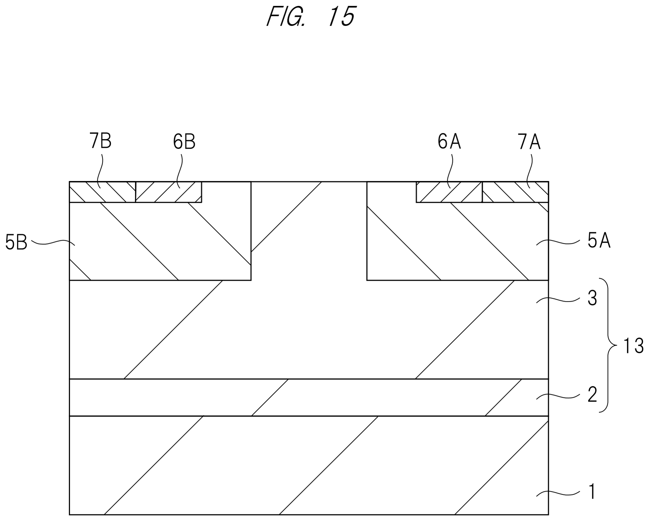

Subsequently, as illustrated in FIG. 15, the p-type well 5A, the p-type well 5B, the source region 6A, the source region 6B, the body contact region 7A, and the body contact region 7B are formed in the drift layer 3 by using, for example, a photolithography technique and an ion implantation method. A thickness of a mask used in the photolithography technique is, for example, about 0.5 $\mu$m or more and 5 $\mu$m or less. As a material of the mask, a silicon oxide film (hard mask), a photoresist film, or the like can be used.

Then, by using an ashing technique, after the mask is removed, a carbon film is formed on each of the upper surface of the epitaxial layer 13 and the lower surface of the silicon carbide substrate 1. The carbon film can be formed by using, for example, a plasma chemical vapor deposition (CVD) method. The thickness of the carbon film is, for example, about 0.03 $\mu$m or more and 0.05 $\mu$m or less.

Next, after the upper surface of the epitaxial layer 13 and the lower surface of the silicon carbide substrate 1 are covered with the carbon film, heat treatment is performed at a temperature of 1500°C or higher for about 2 minutes or more and 3 minutes or less. Thus, a conductivity type impurity introduced into each layer (each region) in the epitaxial layer 13 is activated. Thereafter, the carbon film is removed by, for example, plasma treatment.

Subsequently, as illustrated in FIG. 4, the gate insulating film 8 and an n-type polysilicon film are sequentially formed on the drift layer 3, and then a mask is formed on the n-type polysilicon film. The gate insulating film 8 can be formed using, for example, a thermal oxidation method. The n-type polysilicon film can be formed, for example, by using a CVD method. Next, the n-type polysilicon film is processed by a dry etching method using a mask to form the gate electrode 9. The thickness of the gate insulating film 8 is, for example, about 0.05 $\mu$m or more and 0.15 $\mu$m or less. The thickness of the gate electrode 9 is, for example, about 0.2 $\mu$m or more and 0.5 $\mu$m or less.

Thereafter, the interlayer insulating film 11 is formed on the drift layer 3 so as to cover the gate electrode 9. The interlayer insulating film 11 can be formed by using, for example, a plasma CVD method.

Then, a first through hole TH1 and a second through hole TH2 are formed in the interlayer insulating film 11 by using a photolithography technique and a dry etching technique. As a result, the source region 6A and the body contact region 7A are exposed from a bottom portion of the first through hole TH1, and the source region 6B and the body contact region 7B are exposed from a bottom portion of the second through hole TH2.

Next, a silicide layer (not illustrated) is formed at the bottom portion of the first through hole TH1 and the bottom portion of the second through hole TH2. Thereafter, by using a sputtering method, a metal film is formed so as to fill the inside of the first through hole TH1 and the inside of the second through hole TH2. The metal film includes, for example, a laminated film in which a titanium (Ti) film, a titanium nitride (TiN) film, and an aluminum (Al) film are sequentially laminated. Then, the source electrode 12 made of a metal film is formed by using a photolithography technique and an etching technique. The source electrode 12 is electrically connected to the source region 6A and the body contact region 7A. The source electrode 12 is electrically connected to the source region 6B and the body contact region 7B.

Subsequently, for example, the metal film is formed on the lower surface of the silicon carbide substrate 1 by using a sputtering method, and then a laser silicidation treatment (heat treatment) is performed to react the metal film and the silicon carbide substrate 1 to form a silicide layer (not illustrated). Thereafter, the drain electrode 4 is formed on the lower surface of the silicide layer. The drain electrode 4 can be formed by, for example, a sputtering method. The drain electrode 4 includes, for example, a laminated film in which a titanium film, a nickel film, and a gold film are laminated in order from the silicide layer side. The thickness of the drain electrode 4 is, for example, about 0.5 $\mu$m or more and 1 $\mu$m or less.

As described above, the semiconductor device according to the second embodiment can be manufactured.

<<Verification of Effect>>

Next, it will be described that the power loss of the semiconductor device can be reduced according to the second embodiment by using simulation. Note that the power loss here means a total loss including the ON-state loss, the OFF-state loss, and the switching loss.

The simulation is performed under the following conditions.

Rated current: 40 A

On resistance: $R_{ON}$ = 0.3 $\Omega$

Off current: $I_L$ = 0.1 $\mu$A

Table 1 shows simulation results.

[Table 1]

*Table 1*

| Carrier lifetime $\tau$ ($\mu$s) | Reverse recovery time trr ($\mu$s) | ON-state loss $P_{ON}$ (W) | OFF-state loss $P_{OFF}$ ($\mu$W) | Operating frequency f (kHz) | Switching loss $P_{SW}$ (W) | Power loss Total loss $P_{LOSS}$(W) |
|---|---|---|---|---|---|---|
| 1 | 0.07 | 60 | 30 | 100 | 84 | 144 |
| 1 | 0.07 | 60 | 30 | 20 | 16.8 | 76.8 |
| 1 | 0.07 | 60 | 30 | 5 | 4.2 | 64.2 |
| 0.2 | 0.015 | 60 | 30 | 100 | 18 | 78 |
| 0.2 | 0.015 | 60 | 30 | 20 | 3.6 | 63.6 |
| 0.2 | 0.015 | 60 | 30 | 5 | 0.9 | 60.9 |
| $P_{LOSS}$ = $P_{ON}$ + $P_{OFF}$+ Psw | | | | | | |

The reverse recovery time (trr) of the body diode present in the power MOSFET shows the same tendency as the carrier lifetime ($\tau$). That is, when the carrier lifetime is shortened, the reverse recovery time is also shortened. For example, when $\tau$ = 1 $\mu$s, trr = 0.07 $\mu$s. Meanwhile, when $\tau$ = 0.2 $\mu$s, trr = 0.015 $\mu$s.

Here, assuming a general DC/DC converter (operating frequency f = 100 kHz), the ON-state loss in one power MOSFET is 60 W. Meanwhile, the OFF-state loss of one power MOSFET is 30 $\mu$W. For this reason, the OFF-state loss is smaller than the ON-state loss by six or more orders of magnitude. Meanwhile, the switching loss of one power MOSFET increases to 84 W when $\tau$ = 1 $\mu$s. Meanwhile, the switching loss of one power MOSFET increases to 18 W when $\tau$ = 0.2 $\mu$s. Therefore, according to the semiconductor device in the second embodiment, the power loss in one power MOSFET can be reduced by 45% or more as compared with a case in which $\tau$ = 1 $\mu$s. From this, the simulation results in Table 1 confirm that the power loss of the semiconductor device can be reduced according to the second embodiment.

Assuming an inverter, the operating frequency of the inverter is about f = 5 kHz or more and 20 kHz or less. Therefore, although not to the same extent as a DC/DC converter with an operating frequency of about f = 100kHz, the power loss can also be reduced in the inverter. Specifically, from the simulation results in Table 1, by using the semiconductor device according to the second embodiment for the inverter, the power loss of one power MOSFET can be reduced by about 17% in a case in which the operating frequency is 20 kHz. In a case in which the operating frequency is 5 kHz, the power loss of one power MOSFET can be reduced by about 5%.

The inverter is often used at an operating frequency of about 5 kHz. However, as a countermeasure against noise, it is also being considered to use an inverter at an operating frequency of about 20 kHz, which exceeds the human audible range. Based on the simulation results in Table 1, the effect of reducing the power loss of one power MOSFET is larger in a case in which the operating frequency is 20 kHz than a case in which the operating frequency is 5 kHz. Therefore, future demand for the semiconductor device according to the second embodiment may increase. The inverter having an operating frequency of about 20 kHz is significantly excellent in that the effect of reducing power loss is large.

As described above, when the power loss can be reduced, a cooling mechanism (radiator) of a power conversion device can be downsized. In addition, in the plurality of power MOSFETs constituting the power conversion device, aligning the carrier lifetimes also uniformizes the amount of heat generated from each power MOSFET. As a result, it is not necessary to perform excessive cooling in the cooling mechanism. That is, according to the second embodiment, the cooling mechanism can be downsized by (1) reducing the power loss and (2) uniformizing the amount of heat generated. Therefore, according to the second embodiment, the power conversion device can be downsized.

<Third Embodiment>

<<Necessity of External Diode>>

For example, attention is paid to the inverter INV illustrated in FIG. 3.

A case in which the power MOSFET is used as the switching element 30 constituting the inverter INV will be considered. A body diode is formed parasitically in the power MOSFET. Therefore, the body diode functions as a freewheel diode. For this reason, in a case in which the power MOSFET is used as the switching element 30, the diode FWD externally attached as a freewheel diode is unnecessary.

Meanwhile, a case in which an IGBT is used as the switching element 30 will be considered. A parasitic bipolar transistor is present in the IGBT. In other words, the body diode is not present in the IGBT. Therefore, the IGBT cannot conduct reverse current caused by the motor's inductance. Therefore, in a case in which the IGBT is used as the switching element 30, an external diode FWD functioning as a freewheel diode is required. As the diode FWD, a Schottky barrier diode or a pn junction diode is used. The Schottky barrier diode is a unipolar device. On the other hand, the pn junction diode is a bipolar device. Therefore, the recovery loss occurs in the pn junction diode. Therefore, in a case in which the pn junction diode is used as the diode FWD, the technical idea of the present disclosure capable of reducing the recovery loss is useful.

In the third embodiment, a semiconductor device including the pn junction diode will be described as an example of a semiconductor device manufactured using the semiconductor wafer WF in the first embodiment.

<<Configuration of Semiconductor Device>>

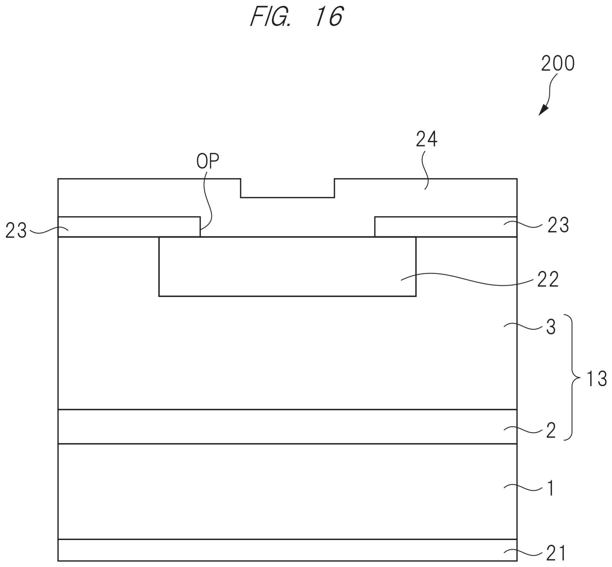

FIG. 16 is a cross-sectional view illustrating a semiconductor device 200 according to the third embodiment.

In FIG. 16, the semiconductor device 200 includes the silicon carbide substrate 1, the buffer layer 2, the drift layer 3, the epitaxial layer 13, a cathode electrode 21, an anode region 22, an insulating film 23, and an anode electrode 24. The anode region 22 may be formed by, for example, ion implantation or an epitaxial layer.

The anode region 22 is a p-type semiconductor region. For example, aluminum which is a p-type impurity is introduced into the anode region 22. The depth of the anode region 22 is about 2 $\mu$m. The impurity concentration (acceptor concentration) of the anode region 22 is, for example, about $2\times10^{18}$ cm$^{-3}$ or more and $1\times10^{20}$ cm$^{-3}$ or less. The anode region 22 is in contact with the drift layer 3 which is an n-type semiconductor layer. Therefore, a pn junction is formed on a boundary surface between the anode region 22 and the drift layer 3. Thus, the semiconductor device 200 includes a pn junction diode.

The anode region 22 is electrically connected to the anode electrode 24. Specifically, the insulating film 23 is formed on the epitaxial layer 13. An opening OP is formed in the insulating film 23. A part of the anode region 22 is exposed at a bottom portion of the opening OP. The anode electrode 24 is formed on the insulating film 23 including the inside of the opening OP. As a result, the anode region 22 and the anode electrode 24 are electrically connected to each other.

Meanwhile, the cathode electrode 21 is formed on the lower surface of the silicon carbide substrate 1. The cathode electrode 21 is electrically connected to the drift layer 3 via the silicon carbide substrate 1 and the buffer layer 2. That is, in the pn junction diode formed by the anode region 22 and the drift layer 3, the anode region 22 is electrically connected to the anode electrode 24, while the drift layer 3 is electrically connected to the cathode electrode 21.

The semiconductor device according to the third embodiment is manufactured using the semiconductor wafer WF according to the first embodiment. Therefore, in the third embodiment, the carrier lifetime distribution including, as an element, the carrier lifetime in the epitaxial layer 13 measured at a plurality of measurement points has the first feature point or the second feature point described above. That is, in the third embodiment, the carrier lifetime in the epitaxial layer 13 can be shortened.

Accordingly, it is possible to promote annihilation of carriers in the epitaxial layer 13. Therefore, according to the third embodiment, the number of carriers swept out from the epitaxial layer 13 can be reduced. Therefore, the recovery current of the pn junction diode used as an external freewheel diode can be reduced. In addition, the reverse recovery time of the pn junction diode can be shortened.

As described above, according to the third embodiment, the recovery loss can be reduced by reducing the recovery current and shortening the reverse recovery time. Accordingly, it is possible to reduce the recovery loss of the pn junction diode, which is a part of the switching loss, in the turn-on time of the IGBT. As a result, the switching loss during the turn-on period can be reduced.

Although the invention made by the present inventors has been specifically described based on the embodiments, the present invention is not limited to the embodiments, and it goes without saying that various modifications can be made without departing from the gist of the present invention.

**Claims**

1.  A semiconductor wafer comprising:

    a silicon carbide substrate having a crystal structure of 4H-SiC; and
    an epitaxial layer formed on the silicon carbide substrate,
    wherein, in a carrier lifetime distribution including, as an element, a carrier lifetime in the epitaxial layer measured at a plurality of measurement points,
    wherein, in a case in which an average value of the carrier lifetime is defined as $\tau_m$, $\tau_m \leq 0.4$ μs is satisfied, and
    wherein, in a case in which a standard deviation of the carrier lifetime distribution is defined as $\sigma_\tau$, $\sigma_\tau \leq 0.5\,\tau_m$ is satisfied.

2.  The semiconductor wafer according to claim 1,
    wherein a diameter of the semiconductor wafer is 145 mm or more.

3.  The semiconductor wafer according to claim 2,
    wherein the diameter of the semiconductor wafer is 195 mm or more.

4.  The semiconductor wafer according to claim 2,
    wherein the carrier lifetime distribution is formed of the carrier lifetime measured in a region excluding a first region, which is a range from an outer peripheral portion of the semiconductor wafer to 2 mm.

5.  The semiconductor wafer according to claim 1,
    wherein, in a case in which a median value of the carrier lifetime is defined as $\tau_c$, $\tau_c \leq 1.5\,\tau_m$ is satisfied.

6.  A semiconductor wafer group including a plurality of the semiconductor wafers according to claim 1,
    wherein, in an average value distribution including, as an element, $\tau_m$ of each of the semiconductor wafers included in the semiconductor wafer group, in a case in which a standard deviation of the average value distribution is defined as $\sigma_{st}$, $\sigma_{st} \leq 0.2$ μs is satisfied.

7.  The semiconductor wafer group according to claim 6,

    wherein the semiconductor wafer group is formed of 25 semiconductor wafers, and
    wherein $\sigma_{st} \leq 0.1$ μs is satisfied.

8.  A semiconductor wafer comprising:

    a silicon carbide substrate having a crystal structure of 4H-SiC; and
    an epitaxial layer formed on the silicon carbide substrate,
    wherein, in a carrier lifetime distribution including, as an element, a carrier lifetime in the epitaxial layer measured at a plurality of measurement points,
    wherein, in a case in which an average value of the carrier lifetime is defined as $\tau_m$, $\tau_m \leq 0.2$ μs is satisfied, and
    wherein, in a case in which a standard deviation of the carrier lifetime distribution is defined as $\sigma_\tau$, $\sigma_\tau \leq 0.05\,\tau_m$ is satisfied.

9.  The semiconductor wafer according to claim 8,
    wherein a diameter of the semiconductor wafer is 145 mm or more.

10. The semiconductor wafer according to claim 9,
wherein the diameter of the semiconductor wafer is 195 mm or more.

11. The semiconductor wafer according to claim 9,
wherein the carrier lifetime distribution is formed of the carrier lifetime measured in a region excluding a second region, which is a range from an outer peripheral portion of the semiconductor wafer to 25 mm.

12. The semiconductor wafer according to claim 8,
wherein, in a case in which a median value of the carrier lifetime is defined as $\tau_c$, $\tau_c \leq 1.5\,\tau_m$ is satisfied.

13. A semiconductor wafer group including a plurality of the semiconductor wafers according to claim 8,
wherein, in an average value distribution including, as an element, $\tau_m$ of each of the semiconductor wafers included in the semiconductor wafer group, in a case in which a standard deviation of the average value distribution is defined as $\sigma_{st}$, $\sigma_{st} \leq 0.2\,\mu s$ is satisfied.

14. The semiconductor wafer group according to claim 13,

wherein the semiconductor wafer group is formed of 25 semiconductor wafers, and
wherein $\sigma_{st} \leq 0.1\,\mu s$ is satisfied.

15. A semiconductor device comprising:

a silicon carbide substrate having a crystal structure of 4H-SiC; and
an epitaxial layer formed on the silicon carbide substrate,
wherein, in a carrier lifetime distribution including, as an element, a carrier lifetime in the epitaxial layer measured at a plurality of measurement points,
wherein, in a case in which an average value of the carrier lifetime is defined as $\tau_m$, $\tau_m \leq 0.4\,\mu s$ is satisfied, and
wherein, in a case in which a standard deviation of the carrier lifetime distribution is defined as $\sigma_\tau$, $\sigma_\tau \leq 0.5\,\tau_m$ is satisfied.

16. The semiconductor device according to claim 15,
wherein the semiconductor device includes a power MOSFET.

17. The semiconductor device according to claim 15,
wherein the semiconductor device includes a pn junction diode.

18. The semiconductor device according to claim 15,
wherein the semiconductor device is a component of a DC/DC converter or an inverter.

19. A semiconductor device comprising:

a silicon carbide substrate having a crystal structure of 4H-SiC; and
an epitaxial layer formed on the silicon carbide substrate,
wherein, in a carrier lifetime distribution including, as an element, a carrier lifetime the epitaxial layer measured at a plurality of measurement points,
wherein, in a case in which an average value of the carrier lifetime is defined as $\tau_m$, $\tau_m \leq 0.2\,\mu s$ is satisfied, and
wherein, in a case in which a standard deviation of the carrier lifetime distribution is defined as $\sigma_\tau$, $\sigma_\tau \leq 0.05\,\tau_m$ is satisfied.

20. The semiconductor device according to claim 19,
wherein the semiconductor device includes a power MOSFET.

21. The semiconductor device according to claim 19,
wherein the semiconductor device includes a pn junction diode.

22. The semiconductor device according to claim 19,
wherein the semiconductor device is a component of a DC/DC converter or an inverter.

## FIG. 1

## FIG. 2

FIG. 3

FIG. 4

FIG. 5

FIG. 6

FIG. 7

FIG. 8A

FIG. 8B

FIG. 8C

FIG. 8D

## FIG. 9

SA1

50

GF1

GF2          GF2

51          WF

52B    52A    52B

GF3          GF3

52

53

FIG. 10

## FIG. 11

## FIG. 12

## FIG. 13

## FIG. 14

FIG. 15

*FIG. 16*

## EUROPEAN SEARCH REPORT

Application Number

EP 26 15 3193

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DANNO KATSUNORI ET AL: "Investigation of carrier lifetime in 4H-SiC epilayers and lifetime control by electron irradiation", APPLIED PHYSICS LETTERS, vol. 90, no. 20, 14 May 2007 (2007-05-14), page 202109, XP093324484, 2 Huntington Quadrangle, Melville, NY 11747 ISSN: 0003-6951, DOI: 10.1063/1.2740580 * pages 202109-1 - 202109-3; figures 1-3 * | 1-22 | INV. H10P14/24 H10D8/00 H10D30/60 H10P14/20 |
| A | CN 110 137 241 A (DENSO CORP) 16 August 2019 (2019-08-16) * the whole document * | 1-20 | |

TECHNICAL FIELDS SEARCHED (IPC)

H10P
H10D

The present search report has been drawn up for all claims

| Place of search | Date of completion of the search | Examiner |
|---|---|---|
| Munich | 15 June 2026 | Norga, Gerd |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 26 15 3193**

This annex lists the patent family members relating to the patent documents cited in the above-mentioned European search report.
The members are as contained in the European Patent Office EDP file on
The European Patent Office is in no way liable for these particulars which are merely given for the purpose of information.

**15-06-2026**

| Patent document cited in search report | Publication date | Patent family member(s) | Publication date |
|---|---|---|---|
| CN 110137241 A | 16-08-2019 | CN 110137241 A | 16-08-2019 |
| | | JP 7106881 B2 | 27-07-2022 |
| | | JP 2019140242 A | 22-08-2019 |
| | | US 2019252503 A1 | 15-08-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2025011533 A
- JP 2025185113 A
- JP 7113882 B
- JP 7298294 B

**Non-patent literature cited in the description**

- **SEIJI ISHIKAWA et al.** Electrical property of 1.2 kV-class SiC Trench MOSFETs on Bonded Substrates. *Japan Society of Applied Physics Advanced Power Semiconductors Division*, 2023